Europäisches Patentamt

European Patent Office

Office européen des brevets

(19)

(11) Veröffentlichungsnummer : **0 202 508**
**B1**

(12) **EUROPÄISCHE PATENTSCHRIFT**

(45) Veröffentlichungstag der Patentschrift :
**11.01.89**

(51) Int. Cl.⁴ : **H 01 L  43/06**

(21) Anmeldenummer : **86105813.9**

(22) Anmeldetag : **26.04.86**

(54) Einrichtung mit einem in einer integrierten Schaltung integrierbaren Hallelement.

(30) Priorität : 22.05.85 CH 2176/85

(43) Veröffentlichungstag der Anmeldung :
26.11.86 Patentblatt 86/48

(45) Bekanntmachung des Hinweises auf die Patenterteilung : 11.01.89 Patentblatt 89/02

(84) Benannte Vertragsstaaten :
AT BE CH DE FR GB IT LI NL SE

(56) Entgegenhaltungen :
IEEE ELECTRON DEVICE LETTERS, Band EDL-5, Nr. 9, September 1984, Seiten 357-358, IEEE, New York, US; R.S. POPOVIC: "The vertical hall-effect device"
IBM TECHNICAL DISCLOSURE BULLETIN, Band 22, Nr. 9, Februar 1980, Seiten 4006-4008, New York, US; S.S. HEGEDUS: "Piezoresistive stress independent hall device
IBM TECHNICAL DISCLOSURE BULLETIN, Band 21, Nr. 7, Dezember 1978, Seiten 2717-2718, New York, US; J.P. BOLASH et al.: "Monolithic hall cell system"

(73) Patentinhaber : LGZ LANDIS & GYR ZUG AG
CH-6301 Zug (CH)

(72) Erfinder : Popovic, Radivoje
Fridbach 1
CH-6300 Zug (CH)
Erfinder : Solt, Katalin
Hofstrasse 45
CH-6300 Zug (CH)
Erfinder : Berchier, Jean-Luc
Neudorfstrasse 32
CH-6313 Menzingen (CH)

(74) Vertreter : Müller, Hans-Jürgen, Dipl.-Ing. et al
Müller, Schupfner & Gauger Lucile-Grahn-Strasse 38
Postfach 80 13 69
D-8000 München 80 (DE)

**Beschreibung**

Die Erfindung bezieht sich auf eine Einrichtung mit einem in einer integrierten Schaltung integrierbaren Hallelement gemäss dem Oberbegriff des Anspruchs 1.

Derartige Einrichtungen werden z. B. in Leistungsmessern oder Elektrizitätszählern verwendet zum Messen eines elektrischen Stromes $i_N$ oder zur Bildung eines Spannungs/Strom-Produktes $u_N \cdot i_N$. Dabei bezeichnet $u_N$ die Netzspannung eines elektrischen Versorgungsnetzes und $i_N$ den von einem Benutzer elektrischer Energie verbrauchten elektrischen Strom. Da der Strom $i_N$ proportional einem von ihm erzeugten Magnetfeld $H_N$ ist, misst das Hallelement indirekt den Strom $i_N$, wenn es das Magnetfeld $H_N$ ermittelt. Da die Ausgangsspannung $V_H$ des Hallelementes proportional dem Produkt $i \cdot H_N$ ist, wobei $i$ den Speisestrom des Hallelementes darstellt, bildet das Hallelement auch das Spannungs/Strom-Produkt $u_N \cdot i_N$, wenn der Speisestrom $i$ des Hallelementes mit Hilfe eines Widerstandes proportional der Netzspannung $u_N$ gewählt wird. In diesem Fall muss das Hallelement als Vierquadrant-Multiplikator arbeiten, da $u_N$ und $i_N$ bzw. $i$ und $H_N$ sinusförmig sind und somit positive und negative Werte besitzen.

Ein integrierbares vertikales Hallelement gemäss dem Oberbegriff des Anspruchs 1 ist aus der Druckschrift « The vertical hall-effect device », R. S. Popovic, IEEE Electron Device Letters, Vol. EDL-5, No. 9, Sept. 84, Seiten 357-358, bekannt. Vertikale integrierbare Hallelemente sind Hallelemente, die Magnetfelder $H_N$ messen, die parallel zur Oberfläche des integrierten Hallelementes wirksam sind.

Betreffend der Stabilität und insbesondere betreffend der Langzeitstabilität von Hallelementen ist, wie z. B. ersichtlich aus der Druckschrift « Hall effect probes and their use in a fully automated magnetic measuring system », M. W. Poole und R. P. Walker, IEEE Transactions on Magnetics, Vol. MAG-17, No. 5, Sept. 81, Seite 2132, nur wenig und nur Prinzipielles bekannt.

Der Erfindung liegt die Aufgabe zugrunde, integrierbare Hallelemente langzeitstabil zu machen unter Verwendung einer Technologie, die es gestattet, gleichzeitig integrierbare Hallelemente und integrierbare Transistoren herzustellen.

Die genannte Aufgabe wird erfindungsgemäss durch die im Kennzeichen des Anspruchs 1 angegebenen Merkmale gelöst.

Weitere Aufgaben, die durch Merkmale von Unteransprüchen gelöst werden, sind integrierbare Hallelemente temperaturstabil zu machen und ihre Kennlinie $V_H = f(B)$ bei konstantem, gegebenem Speisestrom $i$ zu linearisieren. Dabei bezeichnet $V_H$ die Ausgangsspannung des Hallelementes und $B = \mu H_N$ die Induktion des zu messenden Magnetfeldes $H_N$.

Der Anspruch 20 betrifft eine Verwendung der erfindungsgemäßen Einrichtung. Ausführungsbeispiele der Erfindung sind in der Zeichnung dargestellt und werden im folgenden näher beschrieben.

Es zeigen :

Fig. 1 eine Draufsicht einer ersten prinzipiellen Variante eines vergrabenen stabilen Hallelementes,

Fig. 2 einen zur Fig. 1 gehörenden vertikalen Querschnitt des dort dargestellten Hallelementes,

Fig. 3 eine Draufsicht einer ersten praktischen Ausführung des in den Figuren 1 und 2 dargestellten Hallelementes,

Fig. 4 einen zur Fig. 3 und zur Fig. 5 gehörenden vertikalen Querschnitt des dort jeweils dargestellten Hallelementes,

Fig. 5 einen horizontalen Querschnitt einer zweiten praktischen Ausführung des in den Figuren 1 und 2 dargestellten Hallelementes,

Fig. 6 eine Draufsicht zweier Varianten von Sperrschicht-Feldeffekttransistoren, die im gleichen Verfahren hergestellt sind wie die in den Figuren 3 bis 5 dargestellten Hallelemente,

Fig. 7 einen zur Fig. 6 gehörenden vertikalen Querschnitt der dort dargestellten Sperrschicht-Feldeffekttransistoren,

Fig. 8 eine Draufsicht einer zweiten prinzipiellen Variante eines vergrabenen stabilen Hallelementes,

Fig. 9 einen zur Fig. 8 gehörenden vertikalen Querschnitt des dort dargestellten Hallelementes,

Fig. 10 eine Draufsicht einer ersten praktischen Ausführung des in den Figuren 8 und 9 dargestellten Hallelementes,

Fig. 11 einen zur Fig. 10 gehörenden vertikalen Querschnitt des dort dargestellten Hallelementes,

Fig. 12 eine Drausicht eines Sperrschicht-Feldeffekttransistors, der im gleichen Verfahren hergestellt ist wie das in den Figuren 10 und 11 dargestellte Hallelement,

Fig. 13 einen zur Fig. 12 gehörenden vertikalen Querschnitt des dort dargestellten Sperrschicht-Feldeffekttransistors,

Fig. 14 einen horizontalen Querschnitt einer zweiten praktischen Ausführung des in den Figuren 8 und 9 dargestellten Hallelementes,

Fig. 15 einen zu den Figuren 14 und 16 gehörenden vertikalen Querschnitt der dort jeweils dargestellten Hallelemente,

Fig. 16 einen horizontalen Querschnitt einer dritten praktischen Ausführung des in den Figuren 8 und 9 dargestellten Hallelementes,

Fig. 17 ein Anschluss-Schaltbild eines vertikalen Hallelementes mit fünf Anschlüssen,

Fig. 18 ein Blockschaltbild einer Einrichtung mit einem Hallelement,

Fig. 19 eine Kennlinie $V_H = f(B)$ der Ausgangsspannung $V_H$ eines Hallelementes in Funktion einer gemessenen Induktion B bei gegebenem Speisestrom i,

Fig. 20 Kennlinien geradpaariger Nichtlinearitäten $\varepsilon(B)$ und

Fig. 21 Kennlinien ungeradpaariger Nichtlinearitäten $\varepsilon(B)$.

Gleiche Bezugszahlen bezeichnen in allen Figuren der Zeichnung gleiche Teile.

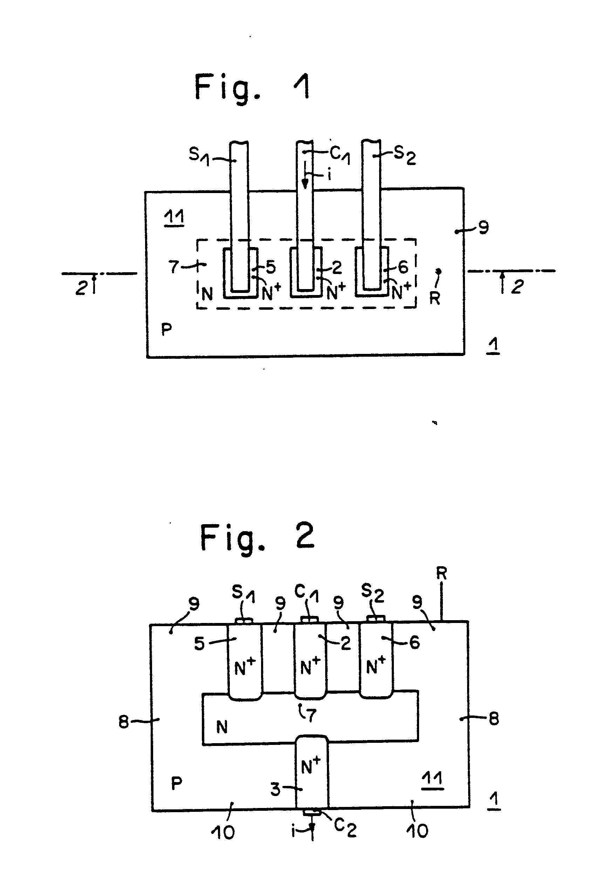

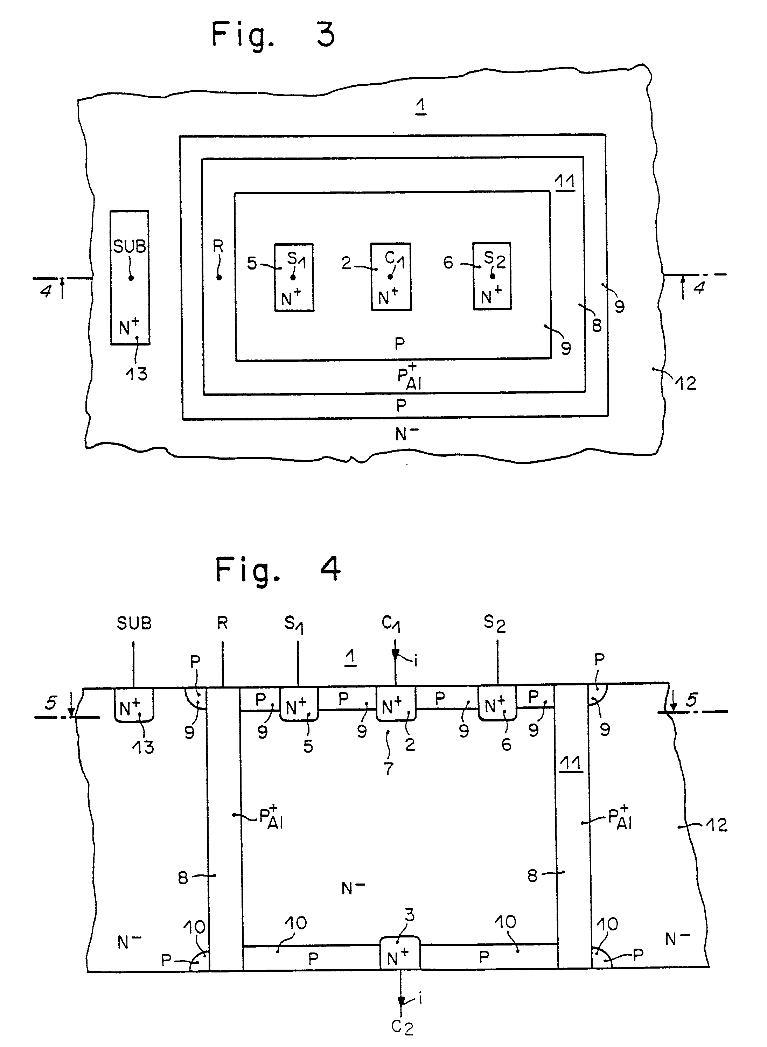

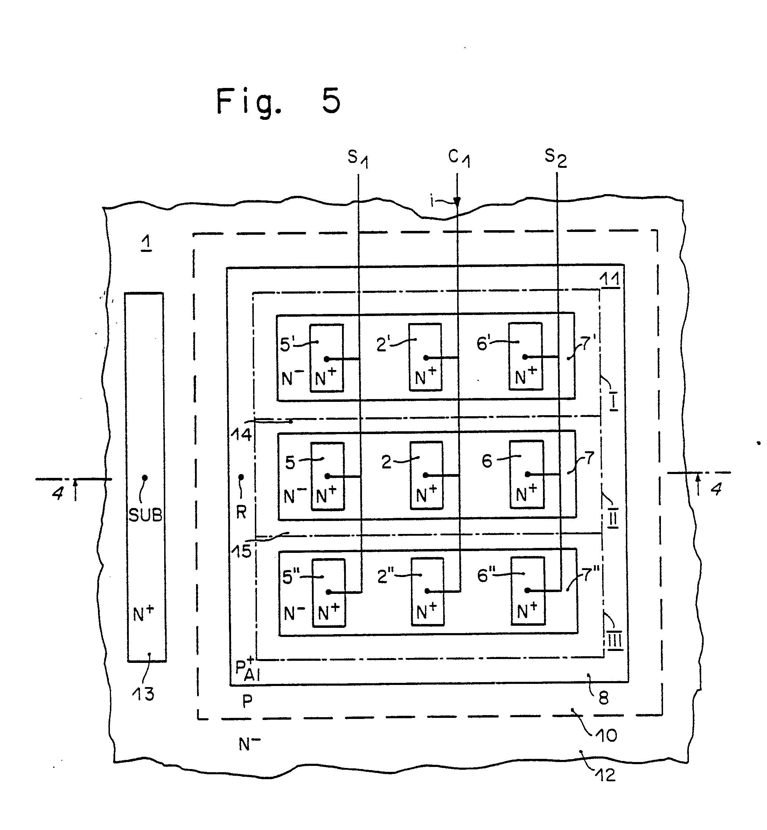

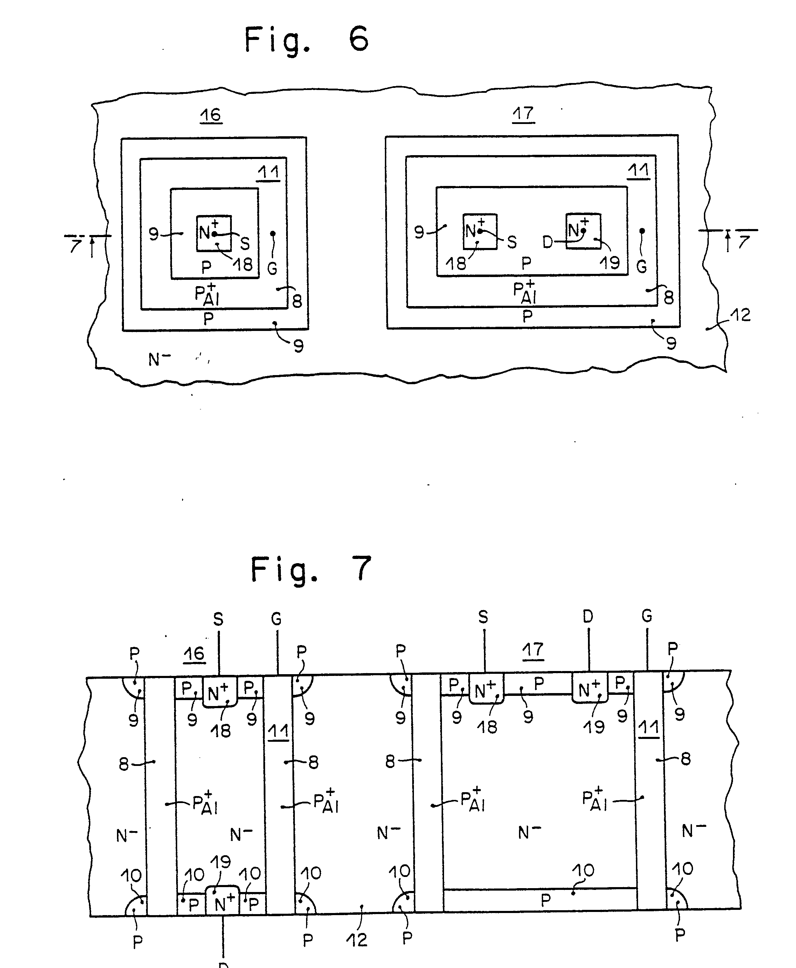

Die in den Figuren 1 bis 16 dargestellten Hallelemente 1 bzw. Sperrschicht-Feldeffektransistoren sind aus Silizium- oder aus Gallium/Arsenid (GaAs)-Material hergestellt. Sie bestehen in der Regel aus Schichten eines dieser beiden Materialien. Alle diese Schichten sind entweder vom Materialleitfähigkeitstyp P oder vom entgegengesetzten Materialleitfähigkeitstyp N. Die Bezeichnungen $N^-$ und $P^-$ deuten an, dass das entsprechende N- bzw. P-Material stark mit Fremtomen dotiert ist, d. h. mindestens eine Konzentration von annähernd $10^{20}$ Ionen pro $cm^3$ besitzt. Umgekehrt deuten die Bezeichnungen $N^-$ und $P^-$ an, dass das entsprechende N- bzw. P-Material schwach mit Fremdatomen dotiert ist.

Die aktiven Zonen der in den Figuren 1 bis 16 dargestellten Hallelemente 1 bzw. Sperrschicht-Feldeffekttransistoren können sowohl aus P- als auch aus N-Material hergestellt werden, was keinen Einfluss auf ihre Funktion hat unter der Bedingung, dass die Polaritäten der zugehörigen Speisespannungen bzw. Speiseströme entsprechend richtig gewählt werden. In der Zeichnung wurde einfachshalber angenommen, dass die aktiven Zonen immer aus N-Material hergestellt sind, was keine Einschränkung des Erfindungsgegenstandes darstellen soll.

In den Figuren 1 bis 16 wurden einfachshalber in der Regel die elektrischen Anschlüsse $C_1$, $C_2$, $C'_2$, $C''_2$, $S_1$, $S_2$, R und SUB des Hallelementes 1 bzw. S, D und G der Sperrschicht-Feldeffekttransistoren als Drähte dargestellt. In der Praxis haben sie natürlich die Gestalt von Metallisierungen, die als dünne Leiterbahnen auf die Oberfläche des integrierten Hallelementes 1 bzw. der dazugehörigen integrierten Schaltung aufgetragen sind.

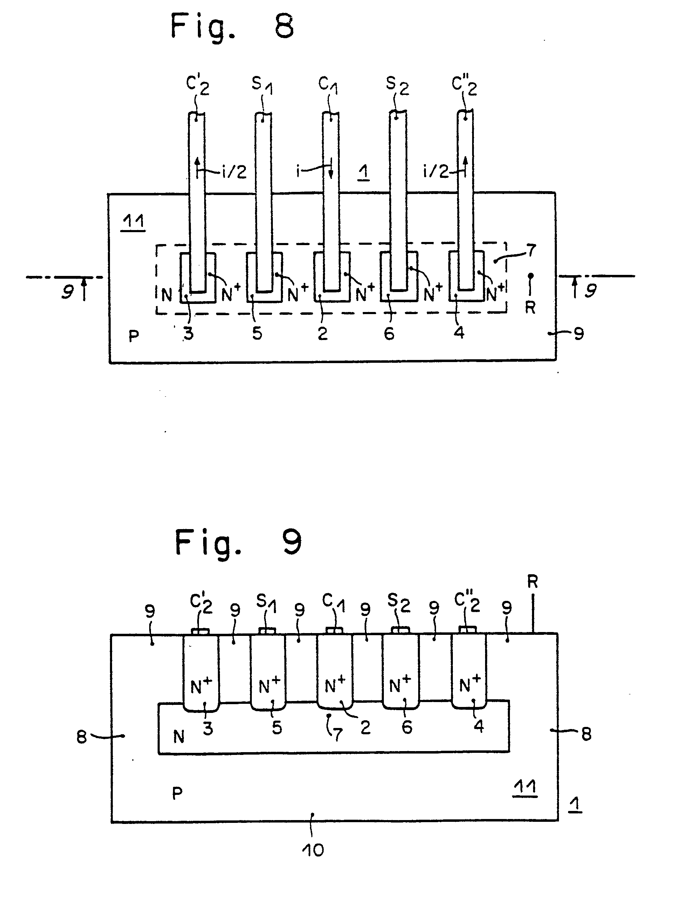

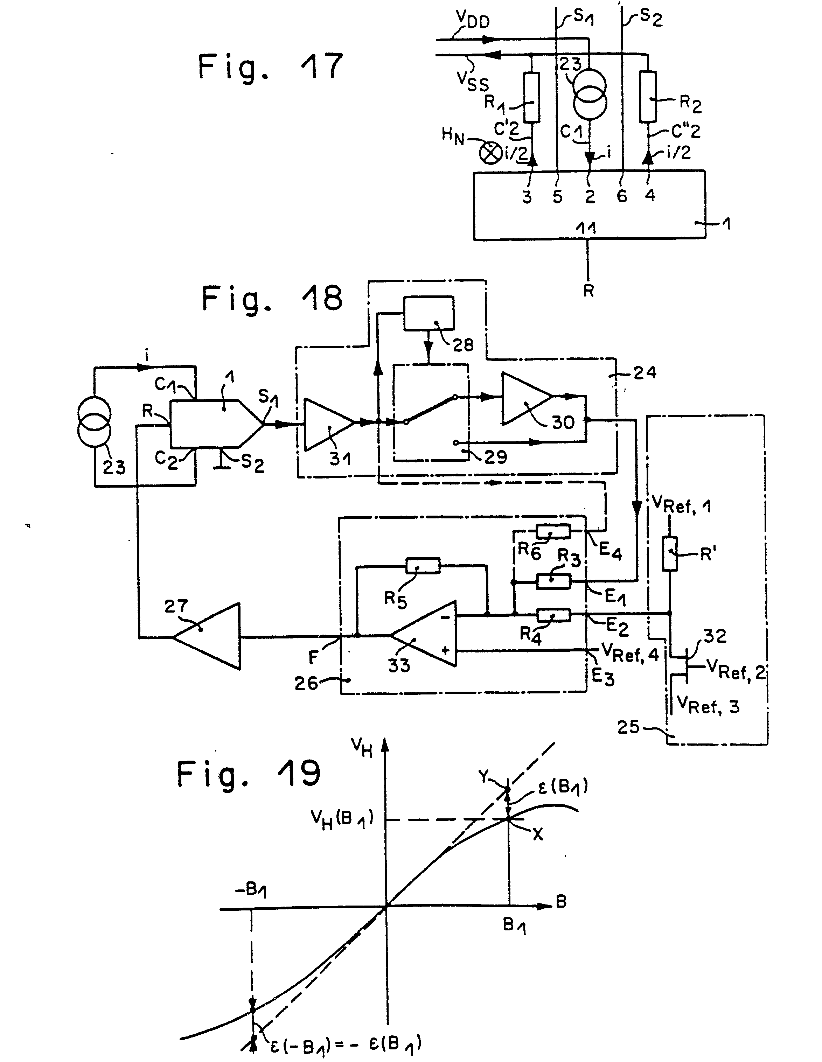

Alle in den Figuren 1 bis 5 dargestellten Hallelemente 1 besitzen zwei Stromanschlüsse $C_1$ und $C_2$ und zwei Sensoranschlüsse $S_1$ und $S_2$. Alle in den Figuren 8 bis 11 und 14 bis 16 dargestellten Hallelemente 1 besitzen drei Stromanschlüsse $C_1$, $C'_2$ und $C''_2$ und zwei Sensoranschlüsse $S_1$ und $S_2$. In diesem Fall ist das Hallelement 1 mit den fünf elektrischen Anschlüssen $C_1$, $C'_2$, $C''_2$, $S_1$ und $S_2$ immer wie in der Fig. 17 dargestellt extern zu beschalten. In der Fig. 18 wurde einfachshalber das Vorhandensein eines Hallelementes 1 mit vier Strom- bzw. Sensor-Anschlüssen $C_1$, $C_2$, $S_1$ und $S_2$ angenommen, was keine Einschränkung auf eine « Vier Anschluss-Variante » darstellen soll. Desgleichen sind die in den Figuren 1 bis 5 dargestellten Lösungen nicht auf « Vier Anschluss-Varianten » und die in den Figuren 8 bis 11 und 14 bis 16 dargestellten Lösungen nicht auf « Fünf Anschluss-Varianten » beschränkt, sondern alle Kombinationen sind möglich.

In allen Varianten liegt z. B. einer der beiden Sensoranschlüsse $S_1$ bzw. $S_2$ an Masse und der andere Sensoranschluss $S_2$ bzw. $S_1$ bildet den Ausgang des Hallelementes 1. In der Zeichnung wurde angenommen, dass der erste Sensoranschluss $S_1$ den Ausgang des Hallelementes 1 bildet und dass der zweite Sensoranschluss $S_2$ an Masse liegt.

Die elektrischen Anschlüsse $C_1$, $C_2$ bzw. $C'_2$, $C''_2$, $S_1$ und $S_2$ des Hallelementes 1 besitzen je einen Anschlusskontakt 2, 3, 4, 5 bzw. 6.

In den Figuren 1 bis 4 sind zwei Sensor-Anschlusskontakte 5 und 6 sowie einer der Strom-Anschlusskontakte, z. B. der zum ersten Stromanschluss $C_1$ gehörende erste Strom-Anschlusskontakt 2, an der Oberfläche im Hallelement 1 angeordnet, während der andere, zum zweiten Stromanschluss $C_2$ gehörende zweite Strom-Anschlusskontakt 3 an der Bodenfläche, dem ersten Strom-Anschlusskontakt 2 diametral gegenüberliegend, im Hallelement 1 angeordnet ist. Die an der Oberfläche angeordneten Anschlusskontakte 2, 5 und 6 sind z. B. alle gleich gross und haben z. B. alle eine gleiche rechteckförmige Gestalt mit abgerundeten Kanten. Sie sind alle annähernd in einer geraden Linie nebeneinander angeordnet, wobei der erste Strom-Anschlusskontakt 2 in der Mitte liegt und die beiden Sensor-Anschlusskontakte 5 und 6 symmetrisch zum ersten Strom-Anschlusskontakt 2 auf der annähernd geraden Linie angeordnet sind. Unterhalb der an der Oberfläche im Hallelement 1 angeordneten drei Anschlusskontakte 2, 5 und 6 befindet sich die aktive Zone 7 des Hallelementes 1.

In den Figuren 8 bis 11 und 14 bis 16 sind alle fünf Anschlusskontakte 2, 3, 4, 5 und 6 an der Oberfläche im Hallelement 1 angeordnet. Die Anschlusskontakte 2 bis 6 sind z. B. alle gleich gross und haben z. B. alle eine gleiche rechteckförmige Gestalt mit abgerundeten Kanten. Sie sind alle annähernd in einer geraden Linie nebeneinander angeordnet, wobei der erste Strom-Anschlusskontakt 2 in der Mitte liegt und die beiden Sensor-Anschlusskontakte 5 und 6 einerseits und die beiden anderen Strom-Anschlusskontakte 3 und 4 anderseits symmetrisch zum ersten Strom-Anschlusskontakt 2 auf der annähernd geraden Linie angeordnet sind. Jeder Sensor-Anschlusskontakt 5 bzw. 6 liegt dabei jeweils zwischen dem ersten Strom-Anschlusskontakt 2 und einem der beiden andern Strom-Anschlusskontakte 3 bzw. 4. Unterhalb der an der Oberfläche im Hallelement 1 angeordneten fünf Anschlusskontakte 2 bis 6 befindet sich die aktive Zone 7 des Hallelementes 1.

Mit andern Worten : Das integrierbare Hallelement 1 besitzt zwei Sensor-Anschlusskontakte 5 und 6 sowie mindestens zwei Strom-Anschlusskontakte 2 und 3, die grösstenteils, d. h. drei von vier oder alle, an der Oberfläche im Hallelement 1 angeordnet sind. Alle Anschlusskontakte 2 bis 6 und die aktive Zone 7 des Hallelementes 1 bestehen aus Material vom gleichen Materialleitfähigkeitstyp wie das Material, aus dem das Hallelement 1 hergestellt ist. Alle Anschlusskontakte 2 bis 6 sind ausserdem stark mit Fremdatomen dotiert. Da das Hallelement 1 als aus N-Material ausgehend hergestellt angenommen wurde, bestehen alle Strom- und Sensor-Anschlusskontakte 2 bis 6 aus N⁻-Material und die aktive Zone 7 des Hallelementes 1 aus N- bzw. N⁻-Material.

Die aktive Zone 7 des Hallelementes 1 ist seitlich von einem Ring 8 umgeben, wobei der Ring 8 jeweils einen Ringanschluss R besitzt. Der Ring 8 ist nicht unbedingt kreisförmig, sondern in der Regel rechteckförmig. Auch braucht er nicht durchgehend zu sein, sondern kann einmal oder mehrmals unterbrochen sein. Er ist immer durch eine Deckplatte 9 und eine Bodenplatte 10 so erweitert, dass der erweiterte Ring 8 ; 9 ; 10, der nachfolgend auch als erweiterter Ring 11 bezeichnet wird, die aktive Zone 7 des Hallelementes 1 nach allen Richtungen hin möglichst vollständig umgibt. Die Sensor- und Strom-Anschlusskontakte 2 bis 6 des Hallelementes 1 durchqueren die Deckplatte 9 oder die Bodenplatte 10 bis zum elektrischen Kontakt mit der aktiven Zone 7 des Hallelementes 1. Der Ring 8, die Deckplatte 9 und die Bodenplatte 10 bestehen aus gleichem oder unterschiedlichem Material, dass aber immer vom gleichen Materialleitfähigkeitstyp ist. In allen Fällen haben der Ring 8, die Deckplatte 9 und die Bodenplatte 10 elektrischen Kontakt miteinander und sie sind alle vom entgegengesetzten Materialleitfähigkeitstyp wie die aktive Zone 7 und die Sensor- und Strom-Anschlusskontakte 2 bis 6 des Hallelementes 1. Sie bestehen in unserem Beispiel also aus P-Material.

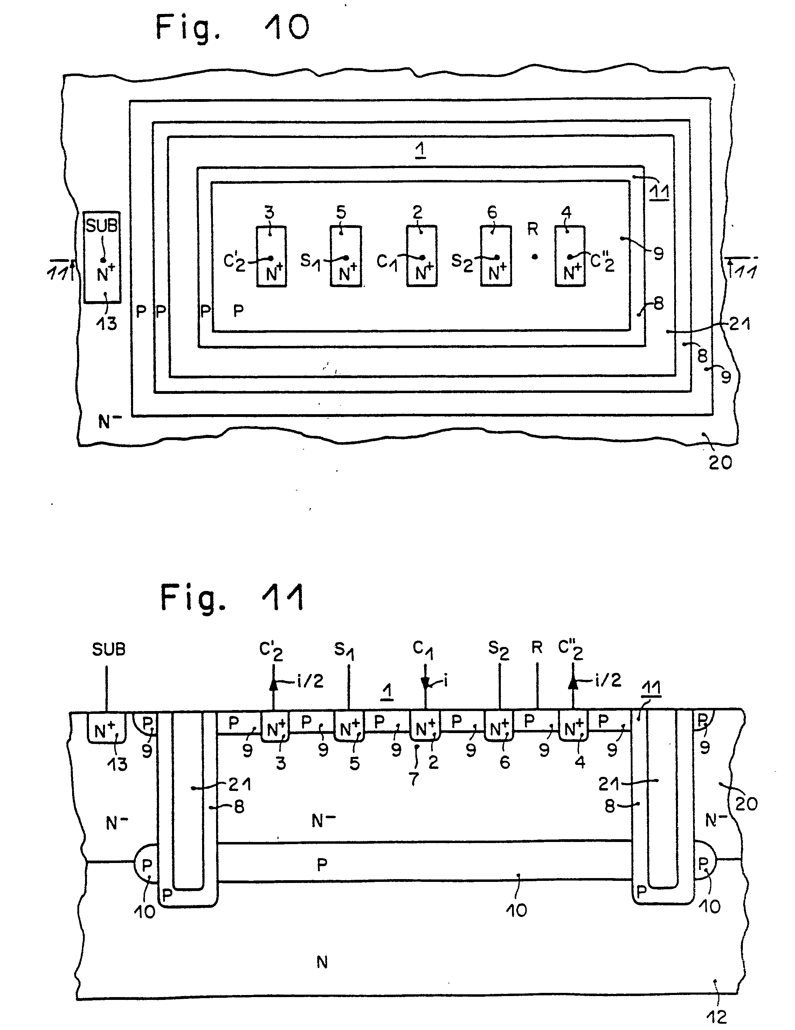

Die Figuren 1 und 2 zeigen die Draufsicht und einen vertikalen Querschnitt einer ersten prinzipiellen Variante eines im Innern des Halbleitermaterials vergrabenen stabilen Hallelemdentes 1. Desgleichen zeigen die Figuren 8 und 9 die Draufsicht und den vertikalen Querschnitt einer zweiten prinzipiellen Variante eines im Innern des Halbleitermaterials vergrabenen stabilen Hallelementes 1. Beide Varianten unterscheiden sich nur durch die Anzahl vier bzw. fünf der vorhandenen Strom- bzw. Sensor-Anschlüsse $C_1$, $C_2$, $S_1$ und $S_2$ bzw. $C_1$, $C'_2$, $C''_2$, $S_1$ und $S_2$ mit ihren jeweiligen Anschlusskontakten 2, 3, 5 und 6 bzw. 2 bis 6. Abgesehen von den Durchführungen für die Strom- und Sensoranschlusskontakte 2, 3, 5 und 6 bzw. 2 bis 6 umgibt der aus dem Ring 8, der Deckplatte 9 und der Bodenplatte 10 bestehende erweiterte Ring 11 die aktive Zone 7 des Hallelements 1 idealerweise vollständig nach allen Richtungen hin, d. h. sowohl seitlich wie auch nach oben und nach unten hin. In beiden Varianten ist der erweiterte Ring 11 aus einem Stück und der Ring 8, die Deckplatte 9 und die Bodenplatte 10 bestehen demnach aus dem gleichen P-Material.

Die Figuren 3 und 4 zeigen die Draufsicht und einen vertikalen Querschnitt einer ersten praktischen Ausführung des in den Figuren 1 und 2 dargestellten Hallelementes 1. Dieses Hallelement 1 ist aus einem Substrat 12 hergestellt, das z. B. aus N⁻-Material besteht. Das Substrat 12 besitzt ausserhalb des erweiterten Ringes 11 einen in seiner Oberfläche angeordneten Substrat-Anschlusskontakt 13 aus stark mit Fremdatomen dotiertem Material vom gleichen Materialleitfähigkeitstyp N wie das Substrat 12 und die aktive Zone 7 des Hallelementes 1, die beide hier aus N⁻-Material bestehen. Der Substrat-Anschlusskontakt 13 besitzt einen Substratanschluss SUB. Der Aufbau dieses Hallelementes 1 ist ähnlich wie derjenige, der in den Figuren 1 und 2 dargestellt ist mit dem Unterschied, dass der Ring 8 aus $P^+_{Al}$-Material besteht, d. h. aus stark mit Aluminium-Fremdatomen dotiertem Material vom Materialleitfähigkeitstyp P. Auch hier bilden der Ring 8, die Deckplatte 9 und die Bodenplatte 10 zusammen eine durchgehende Fläche, die die aktive Zone 7 des Hallelementes 1, einmal von den Durchführungen für die Strom- und Sensor-Anschlusskontakte 2, 3, 5 und 6 abgesehen, vollständig nach allen Richtungen hin umgibt. Der Ring 8 durchquert das Substrat 12 durchgehend von seiner Oberfläche bis zu seiner Bodenfläche und ist z. B. mit Hilfe eines sogenannten Thermomigration-Verfahrens hergestellt. Das Thermomigration-Herstellungsverfahren ist in der Druckschrift « Journal of applied physics, Vol. 48, No. 9, Sept. 77, Seiten 3943 bis 3949, Lamellar devices processed by thermomigration, T. R. Anthony and H. E. Cline » beschrieben.

Die Figuren 5 und 4 zeigen einen horizontalen und einen vertikalen Querschnitt einer zweiten praktischen Ausführung des in den Figuren 1 und 2 dargestellten Hallelementes 1. Diese zweite Ausführung ist eine verbesserte Variante der ersten Ausführung und wird ebenfalls im Thermomigration-Verfahren hergestellt. Die Fig. 5 stellt einen parallel zur Oberläche des Hallelementes 1 verlaufenden Querschnitt des Hallelementes 1 dar, der unmittelbar unterhalb der Deckplatte 9 verläuft (siehe Fig. 4). Das in der Fig. 5 dargestellte Hallelement 1 ähnelt dem in der Fig. 3 dargestellten Hallelement 1 mit dem Unterschied, dass alle gleichnamigen Strom- und Sensor-Anschlusskontakte 2, 3, 5 und 6 in gleicher Anzahl mehrfach vorhanden sind. In der Fig. 5 wurde angenommen, dass alle gleichnamigen Strom- und Sensoranschlusskontakte 2, 3, 5 und 6 jeweils dreimal vorhanden sind, so dass drei erste Strom-Anschlusskontakte 2, 2' und 2", drei zweite Strom-Anschlusskontakte 3, 3' und 3", drei erste Sensor-Anschlusskontakte 5, 5' und 5" und drei zweite Sensor-Anschlusskontakte 6, 6' und 6" existieren. Die drei zweiten Strom-Anschlusskontakte 3, 3' und 3" sind, da bedeckt, in der Fig. 5 nicht sichtbar. Alle Strom- und Sensor-Anschlusskontakte 2, 2', 2", 3, 3', 3", 5, 5', 5", 6, 6' und 6" sind z. B. alle annähernd gleich gross und haben z. B. alle eine gleiche Gestalt, die z. B. rechteckförmig mit abgerundeten Kanten ist. Sie bestehen alle aus Material vom gleichen Materialleitfähigkeitstyp und sind alle stark mit Fremdatomen dotiert. Sie bestehen im dargestellten Beispiel aus N⁻-Material. Alle gleichnamigen Strom- und Sensor-Anschlusskontakte 2, 2', 2" bzw. 3, 3', 3" bzw. 5, 5', 5" bzw. 6, 6', 6" sind extern durch je eine elektrische Verbindung miteinander und mit dem zugehörigen Strom- bzw. Sensoranschluss $C_1$ bzw. $C_2$ bzw. $S_1$ bzw. $S_2$ verbunden. Der Ring 8 besitzt Zwischenstege, die den Ring 8 in nebeneinanderliegende Unterringe unterteilen, wobei jeweils ein Zwischensteg zwei benachbarten Unterringen gemeinsam ist. In der Fig. 5 wurde das Vorhandensein von zwei Zwischenstegen 14 und 15 angenommen, die den Ring 8 in drei Unterringe I, II und III unterteilen. Der Zwischensteg 14 ist den Unterringen I und II und der Zwischensteg 15 den Unterringen II und III gemeinsam. Wenn der Ring 8 und seine Unterringe I, II und III rechteckförmig sind (siehe Fig. 5), dann sind alle gleichnamigen Strom- bzw. Sensor-Anschlusskontakte 2, 2', 2" bzw. 3, 3', 3" bzw. 5, 5', 5" bzw. 6, 6', 6" annähernd in einer geraden Linie übereinander angeordnet, d. h. die Verbindungslinie ihrer Mittelpunkte bildet eine annähernd gerade Linie, wobei alle Verbindungslinien parallel zueinander verlaufen. Die Zwischenstege 14 und 15 sind in diesem Fall alle senkrecht zu diesen Verbindungslinien und alle Unterringe I, II und III sind, ohne gegenseitige Verschiebung, in Richtung der Verbindungslinien übereinander angeordnet, wobei die Breiten der Unterringe I, II und III, senkrecht zu den Verbindungslinien gemessen, alle annähernd gleich gross sind. So entsteht z. B., wenn nur zwei Unterringe vorhanden sind, eine rechteckförmige Acht. Die Aufteilung des Rings 8 in Unterringen I, II und III ist dergestalt, dass jeder Unterring I bzw. II bzw. III eine aktive Zone 7' bzw. 7 bzw. 7" mit einer zugehörigen vollständigen Gruppe 2', 3' 5', 6' bzw. 2, 3, 5, 6 bzw. 2", 3", 5", 6" von ungleichnamigen Strom- und Sensor-Anschlusskontakten seitlich umgibt. Wie aus der Fig. 5 ersichtlich, wechseln sich in der Nähe der Strom- und Sensor-Anschlusskontakte P- und N-Schichten gegenseitig ab, so dass das Hallelement 1 dort einen « Sandwich »-Aufbau besitzt. Dabei sind alle aktiven Zonen 7, 7' und 7" tief im Innern des Hallelementes 1 miteinander verbunden. Dieser « Sandwich »-Aufbau hat den Vorteil, dass die Empfindlichkeit der Dicke der aktiven Zone 7 in Abhängigkeit einer am Ringanschluss R anliegenden elektrischen Spannung um einen Faktor m grösser ist als bei einem Hallelement 1 ohne Zwischenstege, wenn m die Anzahl der Unterringe bezeichnet. Die Figuren 6 und 7 zeigen die Draufsicht und einen vertikalen Querschnitt einer ersten Variante 16 und einer zweiten Variante 17 eines jeweils im Thermomigration-Verfahren hergestellten Sperrschicht-Feldeffekttransistors.

Beide Varianten 16 und 17 unterscheiden sich dadurch, dass bei der ersten Variante 16 ein « Source »-Anschlusskontakt 18 in der Deckplatte 9 und ein « Drain »-Anschlusskontakt 19 in der Bodenplatte 10 angeordnet ist, während bei der zweiten Variante 17 der « Source »-Anschlusskontakt 18 und der « Drain »-Anschlusskontakt 19 beide in der Deckplatte 9 angeordnet sind. Der Aufbau der ersten Variante 16 ist ähnlich wie derjenige des in den Figuren 3 und 4 dargestellten Hallelementes 1, in dem die Sensor-Anschlusskontakte 5 und 6 fehlen und die Strom-Anschlusskontakte 2 und 3 durch die « Source »- und « Drain »-Anschlusskontakte 18 und 19 ersetzt sind. Der Aufbau der zweiten Variante 17 ist ähnlich wie derjenige des in den Figuren 3 und 4 dargestellten Hallelementes 1, in dem die Strom-Anschlusskontakte 2 und 3 fehlen und die Sensor-Anschlusskontakte 5 und 6 durch die « Source »- und « Drain »-Anschlusskontakte 18 und 19 ersetzt sind. In beiden Varianten 16 und 17 ist der Ringanschluss mit G bezeichnet und stellt jeweils den « Gate »-Anschluss des Sperrschicht-Feldeffektransistors dar.

Wie ein Vergleich der Figuren 3 und 4 einerseits und der Figuren 6 und 7 anderseits zeigt, sind die dort dargestellten Bauelemente, nämlich ein Hallelement und ein Sperrschicht-Feldeffekttransistor, ähnlich aufgebaut, so dass es ohne weiteres möglich ist, beide Bauelementearten, die beide je einen erweiterten Ring 8 ; 9 ; 10 besitzen, in einer einzigen integrierten Schaltung mit Hilfe des Thermomigration-Verfahrens einzubauen zwecks Realisierung der in der Fig. 18 dargestellten Schaltung. Der erweiterte Ring 8 ; 9 ; 10 ist dabei für beide Bauelementearten gleich aufgebaut.

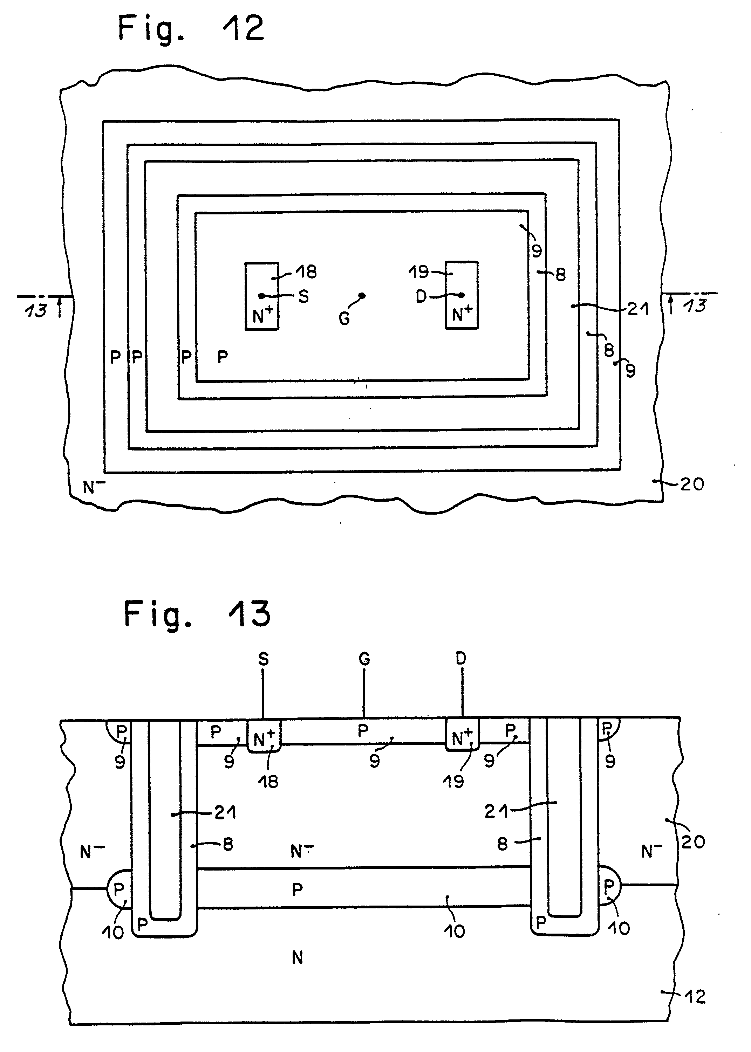

Die Figuren 10 und 11 zeigen die Draufsicht und einen vertikalen Querschnitt einer ersten praktischen Ausführung des in den Figuren 8 und 9 dargestellen Hallelementes 1. Das Hallelement 1 ist z. B. aus einer Schicht 20, die aus N⁻-Material besteht und die auf einem aus N-Material bestehenden Substrat 12 aufgewachsen ist, hergestellt. Die Schicht 20 besitzt ausserhalb des erweiterten Ringes 11 einen in ihrer Oberfläche angeordneten Substrat-Anschlusskontakt 13 aus stark mit Fremdatomen dotiertem Material vom gleichen Materialleitfähigkeitstyp N wie die Schicht 20, das Substrat 12 und die aktive Zone 7 des Hallelementes 1. Die aktive Zone 7 besteht hier aus N⁻-Material der Schicht 20. Der Substrat-Anschlusskontakt 13 besitzt einen Substratanschluss SUB. Der Aufbau des Hallelementes 1 ist ähnlich wie derjenige, der in den Figuren 8 und 9 dargestellt ist mit dem Unterschied, dass der Ring 8 aus einer Oberflächenschicht aus P-Material besteht, die rund herum auf einem ringförmigen Träger 21 aus Siliziumoxyd oder Polysilizium aufgetragen ist. Die Oberflächenschicht 8 aus P-Material fehlt auf dem Träger 21 nur zur Oberfläche der integrierten Schaltung hin. Der ringförmige Träger 21 und die zu ihm gehörende Oberflächenschicht 8 durchqueren die Schicht 20 durchgehend von deren Oberfläche bis zum elektrischen Kontakt mit dem Substrat 12, in dem sie sogar eindringen können. Der ringförmige Träger 21 mit seiner Oberflächenschicht 8 wird z. B. mit Hilfe eines « Tiefen Graben »-Aetzverfahrens (« anisotropic trench etching ») hergestellt, welches in der Druckschrift « Electronics Week, July 23, 1984, Seiten 123 bis 126, 1 MB Memories demand new design choices, White, Armstrong and Rao » beschrieben ist. Die Bodenplatte 10 befindet sich als vergrabene Schicht (« burried layer ») an der Grenze zwischen der Schicht 20 und dem Substrat 12 und hat elektrischen Kontakt mit der Oberflächenschicht 8, die ebenfalls elektrischen Kontakt zur Deckplatte 9 besitzt.

Die Figuren 12 und 13 zeigen die Draufsicht und einen vertikalen Querschnitt eines im « Tiefen Graben »-Aetzverfahren hergestellten Sperrschicht-Feldeffektransistors. Der Aufbau ist ähnlich wie derjenige des in den Figuren 10 und 11 dargestellten Hallelementes 1 mit dem Unterschied, dass anstelle der fünf Anschlusskontakte 2 bis 6 nur mehr zwei Anschlusswkontakte, nämlich ein « Source »- und ein « Drain »-Anschlusskontakt 18 und 19 vorhanden sind. Der Ringanschluss ist hier mit G bezeichnet und bildet den « Gate »-Anschluss des Sperrschicht-Feldeffekttransistors. Wie ein Vergleich der Figuren 10 und 11 einerseits und der Figuren 12 und 13 anderseits zeigt, sind die dort dargestellten Bauelemente, nämlich ein Hallelement und ein Sperrschicht-Feldeffektransistor, ähnlich aufgebaut, so dass es ohne weiteres möglich ist, beide Bauelementearten, die beide je einen erweiterten Ring 8 ; 9 ; 10 besitzen, in einer einzigen integrierten Schaltung mit Hilfe eines « Tiefen Graben » Aetzverfahrens einzubauen zwecks Realisierung der in der Fig. 18 dargestellten Schaltung. Der erweiterte Ring 8 ; 9 ; 10 ist auch hier für beide Bauelementearten gleich aufgebaut.

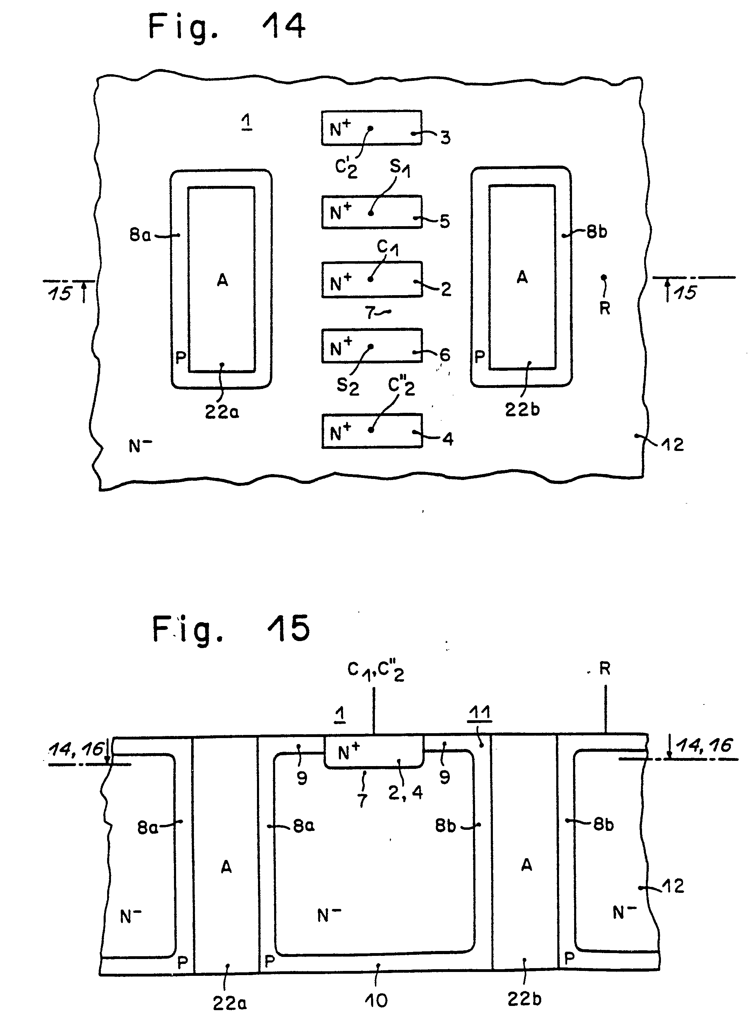

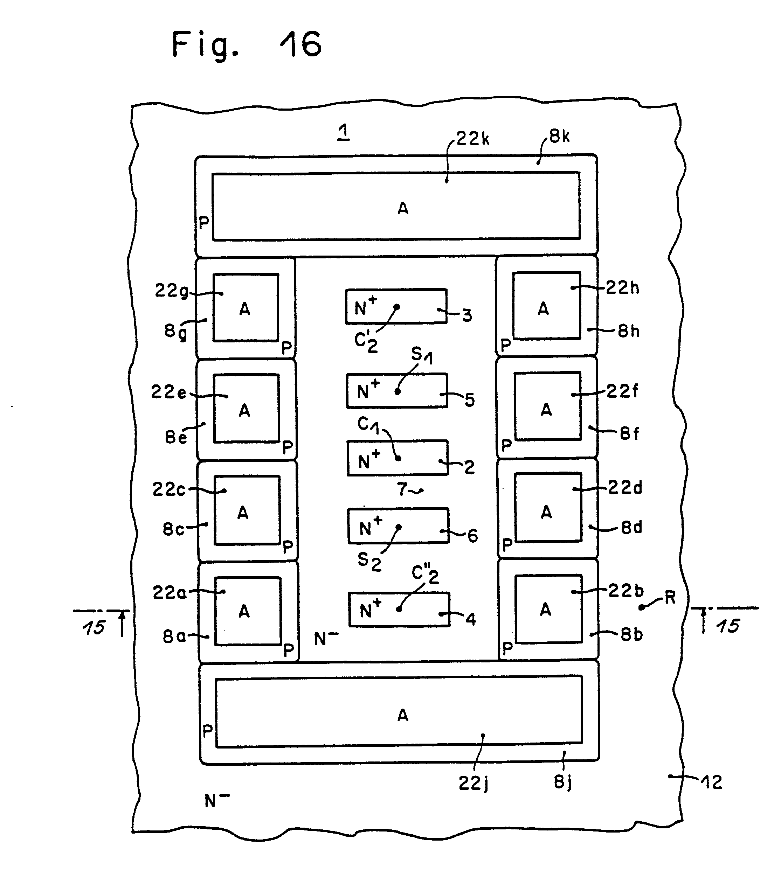

Die Figuren 14 und 15 zeigen einen horizontalen und einen vertikalen Querschnitt einer zweiten praktischen Ausführung des in den Figuren 8 und 9 dargestellten Hallelementes 1. Da ein tiefer und dünner rechtförmiger Träger 21 gemäss den Figuren 12 und 13 nur schwierig herstellbar ist, stellt diese zweite Ausführung eine verbesserte Variante der ersten Ausführung dar. Die Fig. 14 ist die Wiedergabe eines parallel zur Oberfläche des Hallelementes 1 verlaufenden Querschnittes des Hallelementes 1, der unmittelbar unterhalb der Deckplatte 9 verläuft (siehe Fig. 15). Im Vergleich zur Fig. 8 ist die Fig. 14 um 90° verdreht dargestellt, so dass die fünf Strom- und Sensor-Anschlusskontakte 2 bis 6 nicht in einer annähernd geraden Linie nebeneinander, sondern in einer annähernd geraden Linie überneinander angeordnet dargestellt sind, was keinen Einfluss auf die Funktion des Hallelementes 1 hat. Abgesehen von der Anzahl Strom- und Sensor-Anschlusskontakte 2 bis 6, die hier gleich fünf ist, hat das in den Figuren 14 und 15 dargestellte Hallelement 1 einen ähnlichen Aufbau wie das in den Figuren 3 und 4 dargestellte Hallelement 1. Auch hier ist das Hallelement 1 aus einem Substrat 12 hergestellt, das aus $N^-$-Material besteht, so dass die aktive Zone 7 des Hallelementes 1 ebenfalls aus $N^-$-Material ist. Im Unterschied zu dem in den Figuren 3 und 4 dargestellten Hallelement 1 besteht der als rechteckförmig ausgebildete Ring 8 hier nur aus zwei diametral gegenüberliegenden Seiten, die je aus einer Oberflächenschicht 8a bzw. 8b aus P-Material gebildet sind, die die seitlichen Innenflächen je eines z.B. rechteckförmigen Luftschachtes 22a bzw. 22b vollständig und durchgehend bedecken. Der Buchstabe A bezeichnet in den Figuren 14 und 15 Luft (« Air »). Die beiden Luftschächte 22a und 22b durchqueren das Substrat 12, aus dem das Hallelement 1 und die integrierte Schaltung hergestellt ist, vollständig durchgehend von der Oberfläche bis zur Bodenfläche. Die Oberflächenschichten 8a und 8B werden z.B. durch die Diffusion von Gas erzeugt, das an den Grenzflächen zwischen Luft und Substrat 12 in das Substratmaterial eindringt und dort die Oberflächenschichten 8a und 8b erzeugt. Die Oberflächenschichten 8a und 8b, die Deckplatte 9 und die Bodenplatte 10 haben alle elektrischen Kontakt zueinander und bilden zusammen eine durchgehende Fläche, die die aktive Zone 7 des Hallelementes 1 möglichst vollständig nach oben, nach unten und nach zwei Seiten hin umgibt. Wenn die beiden Seiten des Ringes 8, wie in den Figuren 14 und 15 dargestellt, parallel zur Verbindungslinie der Mittelpunkte der Strom- und Sensor-Anschlusskontakte 2 bis 6 verlaufen, ist die durchgehende Fläche maximal und seitlich nur zu den relativ kurzen Stirnseiten hin offen. Die Oberflächenschichten 8a und 8b, die Deckplatte 9 und die Bodenplatte 10 sind alle vom gleichen Materialleitfähigkeitstyp, nämlich vom Typ P, und vom entgegengesetzten Materialleitfähigkeitstyp wie die aktive Zone 7 des Hallelementes 1 und das Substrat 12, die beide, wie bereits erwähnt, aus $N^-$-Material bestehen. Der durchgehende P/N-Uebergang zwischen den Oberflächenschichten 8a und 8b, der Deckplatte 9 und der Bodenplatte 10 einerseits und der aktiven Zone 7 des Hallelementes 1 anderseits bildet eine Sperrschicht, die die aktive Zone 7 vollständig umgibt, ausser seitlich zu den beiden kurzen Stirnseiten des Ringes 8 hin.

Um den Nachteil zu vermeiden, dass die durchgehende Fläche und die Sperrschicht zur Stirnseite hin offen sind, kann der rechteckförmig ausgebildete Ring 8 zur Stirnseite hin erweitert werden (siehe Fig. 16). Er besteht dann aus mindestens vier Oberflächenschichten 8a, 8b, 8j und 8k, von denen je zwei und zwei diametral gegenüberliegen und die die seitlichen Innenflächen je eines Luftschachtes 22a, 22b, 22j bzw. 22k vollständig und durchgehend bedecken, wobei die Luftschächte 22a, 22b, 22j und 22k das Substrat 12, aus dem das Hallelement 1 hergestellt ist, vollständig durchgehend von der Oberfläche biz zur Bodenfläche durchqueren. Die Oberflächenschichten 8a, 8b, 8j und 8k, die Deckplatte 9 und die Bodenplatte 10 haben alle elektrischen Kontakt zueinander und bilden zusammen eine durchgehende Fläche, die die aktive Zone 7 des Hallelementes 1 möglichst vollständig nach allen Richtungen hin umgibt. Die Oberflächenschichten 8a, 8b, 8j und 8k, die Deckplatte 9 und die Bodenplatte 10 sind alle vom gleichen Materialleitfähigkeitstyp, z.B. P, und alle vom entgegengesetzten Materialleitfähigkeitstyp wie die aktive Zone 7 des Hallelementes 1, die ja aus N-Material besteht. Die Luftschächte 22j und 22k mit ihren Oberflächenschichten 8j und 8k sind in der Fig. 16 dargestellt.

Wenn die Luftschächte 22a, 22b, 22j oder 22k zumindest teilweise sehr lang sind, besteht die Gefahr, dass das Hallelement 1 sich unter den Einfluss eines äusseren mechanischen Druckes durchbiegt oder sogar bricht. Um dies zu vermeiden, müssen mindestens diese langen Luftschächte durch Zwischenstege in z.B. parallelen Teilluftschächte unterteilt werden. In der Fig. 16 wurde angenommen, dass die beiden diametral gegenüberliegenden Luftschächte, deren Längsrichtung parallel zur Verbindungslinie der Mittelpunkte der Anschlusskontakte 2 bis 6 verläuft, lang sind und durch Zwischenstege, die senkrecht zu dieser Verbindungslinie verlaufen, in je eine z.B. gleiche Anzahl vier annähernd gleich grosser Teilluftschächte 22a, 22c, 22e und 22g bzw. 22b, 22d, 22f und 22h unterteilt sind. Die seitlichen Innenflächen der Teilluftschächte 12a, 12b, 12c, 12d, 12e, 12f, 12g und 12h sind vollständig mit je einer durchgehenden Oberflächenschicht 8a, 8b, 8c, 8d, 8e, 8f, 8g bzw. 8h bedeckt. Die Figuren 16 und 15 zeigen einer horizontalen und einen vertikalen Querschnitt einer dritten praktischen Ausführung des in den Figuren 8 und 9 dargestellten Hallelementes 1. Diese dritte Ausführung ist eine verbesserte Variante der zweiten Ausführung. Die Fig. 16 stellt einen parallel zur Oberfläche des Hallelementes 1 verlaufenden Querschnitt des Hallelementes 1 dar, der unmittelbar unterhalb der Deckplatte 9 verläuft (siehe Fig. 15).

Wenn alle Zwischenstege höchstens zweimal so breit sind wie die Oberflächenschichten tief sind, so bestehen die Zwischenstege ausschliesslich aus zwei Oberflächenschichten zweier benachbarten Teilluftschächte und alle Oberflächenschichten 8a, 8c, 8e, 8g bzw. 8b, 8d, 8f, 8h eines gemeinsamen Luftschachtes haben jeweils alle elektrischen Kontakt zueinander. Auch die Oberflächenschichten 8a bis 8h, die Deckplatte 9, die Bodenplatte 10 und, falls stirnseitige Luftschächte 22j und 22k vorhanden sind, die Oberflächenschichten 8j und 8k besitzen alle elektrischen Kontakt zueinander. Sie bilden zusammen eine durchgehende Fläche, die die aktive Zone 7 des Hallelementes 1 möglichst vollständig mindestens nach oben, nach unten und nach zwei Seiten hin umgibt, und sie sind alle vom gleichen Materialleitfähigkeitstyp P und vom entgegengesetzten Materialleitfähigkeitstyp wie die aktive Zone 7 des Hallelementes 1, die ja aus $N^-$-Material besteht.

Die in den Figuren 8 bis 11 und 14 bis 16 dargestellten Hallelemente 1 mit fünf Strom- bzw. Sensor-Anschlüsse $C_1$, $C'_2$, $C''_2$, $S_1$ und $S_2$ sind extern wie in der Fig. 17 dargestellt zu beschalten. Ein zu messendes Magnetfeld $H_N$ wirkt parallel zur Oberfläche der das Hallelement 1 enthaltenden integrierten Schaltung. Ein Pol $V_{DD}$ einer Speisespannung $V_{DD}$; $V_{SS}$ ist über einen Stromgenerator 23 mit dem zentralen Stromanschluss $C_1$ verbunden, während der andere Pol $V_{SS}$ der Speisespannung $V_{DD}$; $V_{SS}$ über je einen Widerstand $R_1$ bzw. $R_2$ auf die beiden andern Stromanschlüsse $C'_2$ bzw. $C''_2$ geführt ist. Der vom Stromgenerator 23 gelieferte Speisestrom i des Hallelementes 1 halbiert sich innerhalb des Hallelementes 1 und verlässt jeweils als Strom i/2 über die beiden Widerstände $R_1$ bzw. $R_2$ das Hallelement 1.

Die in der Fig. 18 dargestellte Einrichtung enthält neben dem Hallelement 1 und dem Stromgenerator 23 noch eine Regelungsschaltung 24 ; 25 ; 26 ; 27. In der Fig. 18 wurde angenommen, dass das Hallelement 1 eines der in den Figuren 1 bis 5 dargestellten Hallelemente 1 ist, welche alle neben dem Ringanschluss R nur vier Strom- bzw. Sensoranschlüsse $C_1$, $C_2$, $S_1$ und $S_2$ besitzen. In diesem Fall sind die beiden Stromanschlüsse $C_1$ und $C_2$ mit je einem Pol des Stromgenerators 23 verbunden. Ist dagegen das in der Fig. 18 verwendete Hallelement 1 eines der in den Figuren 8 bis 11 oder 14 bis 16 dargestellten Hallelemente 1, welche alle neben dem Ringanschluss R noch fünf Strom- bzw. Sensoranschlüsse $C_1$, $C'_2$, $C''_2$, $S_1$ und $S_2$ besitzen, so ist, wie bereits erwähnt, die in der Fig. 17 dargestellte Beschaltung des Hallelementes 1 zu verwenden. In beiden Fällen liegt einer der beiden Sensoranschlüsse, z.B. der zweite Sensoranschluss $S_2$, an Masse, während der andere erste Sensoranschluss $S_1$ den Ausgang $S_1$ des Hallelementes 1 bildet.

In allen beschriebenen Hallelementen 1 bildet der P/N-Uebergang zwischen dem erweiterten Ring 11 und der aktiven Zone 7 des Hallelementes 1 eine Sperrschicht 11 ; 7, die die aktive Zone 7 des Hallelementes 1 möglichst vollständig umgibt, und deren Tiefe mit Hilfe einer am Ringanschluss R anliegenden elektrischen Spannung gesteuert werden kann. Die Sperrschicht 11 ; 7 isoliert und schützt vollständig die aktive Zone 7 des Hallelementes 1, so dass das Vorhandensein einer Isolierschicht aus Siliziumoxyd überflüssig ist. Die immer in einer solchen Isolierschicht aus Siliziumoxyd enthaltene variable Anzahl von Ladungsträgern ist demnach hier nicht vorhanden und kann daher auch die Langzeitstabilität des Hallelementes 1 nicht negativ beeinflussen. Die schützende Wirkung der Sperrschicht 11 ; 7 ist um so stärker, je vollständiger sie die aktive Zone 7 des Hallelementes 1 nach möglichst allen Richtungen hin umgibt, und hängt ausserdem von ihrer Tiefe ab. Diese Tiefe sollte trotz Vorhandensein von möglichen Störeinflüssen, z.B. von veränderlichen Temperatureinflüssen, immer konstant sein. Um dies zu erreichen, ist das Hallelement 1 wie in der Fig. 18 dargestellt mit einer Regelungsschaltung 24 ; 25 ; 26 ; 27 zu beschalten, welche die Tiefe der Sperrschicht 11 ; 7 auf einen konstanten Wert regelt.

In der Fig. 18 ist der Ausgang $S_1$ des Hallelementes 1 über die Regelungsschaltung 24 ; 25 ; 26 ; 27 mit dem Ringanschluss R des Hallelementes 1 verbunden. Die Regelungsschaltung 24 ; 25 ; 26 ; 27 besteht mindestens aus einem Istwertaufbereiter 24, einem Sollwertgeber 25 und einem Sollwert/Istwert-Differenzgeber 26 ; 27. Der Ausgang $S_1$ des Hallelementes 1 ist über den Istwertaufbereiter 24 mit einem ersten Eingang $E_1$ des Sollwert/Istwert-Differenzgebers 26 ; 27 und der Ausgang des Sollwertgebers 25 direkt mit dessem zweiten Eingang $E_2$ verbunden. Der Ausgang des Sollwert/Istwert-Differenzgebers 26 ; 27 ist auf den Ringanschluss R des Hallelementes 1 geführt. Der Istwertaufbereiter 24 ist im einfachsten Fall ein Absolutwertbildner, z.B. ein Gleichrichter, dessen Ausgangsspannung immer gleich dem Absolutwert seiner Eingangsspannung ist.

In der Fig. 18 besteht der Absolutwertbildner und damit auch der Istwertaufbereiter 24 mindestens aus einem von einem Steuergerät 28 gesteuerten Umschalter 29 und aus einem invertierenden Verstärker 30. In der Fig. 18 besitzt der Istwertaufbereiter 24 noch zur Entkopplung einen Spannungsfolger 31, der fakultativ vorhanden ist. Innerhalb des Istwertaufbereiters 24 ist dessen Eingang direkt oder über den Spannungsfolger 31 je nach Stellung des Umschalters 29 durch diesen Umschalter 29 entweder mit dem Eingang oder mit dem Ausgang des invertierenden Verstärkers 30 verbunden. Der Ausgang des invertierenden Verstärkers 30 bildet den Ausgang des Istwertaufbereiters 24 und ist demnach auf den ersten Eingang $E_1$ des Sollwert/Istwert-Differenzgebers 26 ; 27 geführt. Der Eingang des Istwertaufbereiters 24 ist ausserdem noch direkt oder über den Spannungsfolger 31 mit dem Eingang des Steuergerätes 28 verbunden, dessen Ausgang auf den Steuereingang des Umschalters 29 geführt ist. Das Steuergerät 28 besteht z.B. aus nur einem Komparator und detektiert die Polarität der Eingangsspannung des Istwertaufbereiters 24 und damit auch die Polarität der Ausgangsspannung $V_H$ des Hallelementes 1. Je nach Polarität dieser Ausgangsspannung $V_H$ überbrückt oder nimmt der Umschalter 29 den invertierenden Verstärker 30 in Betrieb. Mit andern Worten : Ist die Ausgangsspannung $V_H$ des Hallelementes 1 positiv, wird sie direkt ohne Vorzeichen-Invertierung, und ist sie negativ, wird sie durch den invertierenden Verstärker 30 mit Vorzeichen-Invertierung jeweils an den ersten Eingang $E_1$ des Sollwert/Istwert-Differenzgebers 26 ; 27 weitergeleitet.

Der Sollwertgeber 25 besteht z.B. aus der Reihenschaltung eines Vorwiderstandes $R'$ und der « Source-Drain »-Strecke eines Feldeffekttransistors 32, deren gemeinsamer Pol den Ausgang des Sollwertgebers 25 bildet und somit mit dem zweiten Eingang $E_2$ des Sollwert/Istwert-Differenzgebers 26 ; 27 verbunden ist. Der andere Pol des Vorwiderstandes $R'$ liegt an einer ersten Referenzspannung $V_{Ref.1}$, der « Gate »-Anschluss des Feldeffektransistors 32 an einer zweiten Referenzspannung $V_{Ref.2}$ und der andere Pol der « Source-Drain »-Strecke des Feldeffektransistors 32 an einer dritten Referenzspannung $V_{Ref.3}$.

Der Sollwert/Istwert-Differenzgeber 26 ; 27 besteht mindestens aus einem Differenzverstärker 26, der z.B. auf an sich bekannte Art mit Hilfe eines Operationsverstärkers 33 aufgebaut ist. In diesem Fall ist der invertierende Eingang des Operationsverstärkers 33 über einen ersten Eingangswiderstand $R_3$ mit dem ersten Eingang $E_1$, über einen zweiten Eingangswiderstand $R_4$ mit dem zweiten Eingang $E_2$ und über einen Rückkopplungswiderstand $R_5$ mit dem Ausgang F jeweils des Differenzverstäkers 26 verbunden. Der Ausgang F ist gleichzeitig auch der Ausgang des Operationsverstärkers 33. Der nichtinvertierende Eingang des Operationsverstärkers 33 liegt über einen dritten Eingang $E_3$ des Differenzverstärkers 26 an einer vierten Referenzspannung $V_{Ref.4}$. Der Differenzverstärker 26 ist z.B. als invertierender Verstärker beschaltet. In diesem Fall muss ihm ein weiterer Verstärker 27 in Kaskade nachgeschaltet werden z.B. zwecks Rückgängigmachung der durch den Differenzverstärker 26 verursachten Invertierung. Die beiden Verstärker 27 und 30 besitzen z.B. je einen Verstärkungsfaktor — 1 und sind z.B. ebenfalls mit je einem Operationsverstärker auf an sich bekannte Art aufgebaut.

Der Feldeffekttransistor 32 dient als temperaturempfindliches Element, dessen Sättigungs (« Pinch off ») -Strom umgekehrt proportional dem Quadrat der Umgebungstemperatur des Feldeffekttransistors 32 und auch des Hallelementes 1 ist, da diese beiden Bauelemente, dank ihres Einbaus in einer integrierten Schaltung, räumlich sehr nahe beieinander liegen. Dies zeigt wiederum, wie wichtig es ist, dass sowohl das Hallelement 1 als auch Transistoren wie z.B. der Feldeffekttransistor 32, im gleichen Halbleiter-Kristall mit Hilfe der gleichen Technologie integrierbar sind. Die Regelungsschaltung 24 ; 25 ; 26 ; 27 regelt die Dicke der Sperrschicht 11 ; 7, indem sie die Ausgangsspannung des Hallelementes 1 als Istwert mit dem vom Sollwertgeber 25 gelieferten Sollwert vergleicht und eine so erhaltene Sollwert/Istwert-Differenz verstärkt auf den Ringanschluss R des Hallelementes 1 gibt. Da der Feldeffekttransistor 32 ein temperaturempfindliches Bauelement ist, ist auch der Sollwert temperaturabhängig. Dies gestattet es der Regelungsschaltung 24 ; 25 ; 26 ; 27, in diesem Fall die Dicke der Sperrschicht 11 ; 7 auf einen Wert zu regeln, der es ermöglicht, dass die Magnetfeld-Empfindlichkeit des Hallelementes 1 unabhängig von der Temperatur bleibt. Ist das Hallelement 1 von sich aus genügend temperaturstabil, so ist der Feldeffekttransistor 32 überflüssig und kann weggelassen werden.

Der Umschalter 29 ist in der Fig. 18 als Relaiskontakt dargestellt. In der Praxis ist er jedoch in der Regel ein steuerbarer Halbleiter-Umschalter, der z.B. in CMOS-Technologie hergestellt ist. Die in der Regelschaltung 24 ; 25 ; 26 ; 27 verwendeten Transistoren, wie der Feldeffekttransistor 32, haben z.B. einen wie in den Figuren 6 und 7 oder 12 und 13 dargestellten Aufbau.

Die in der Fig. 18 dargestellte Schaltung hat ausserdem noch den Vorteil, die Kennlinie $V_H = f(B)$ des Hallelementes 1 bei gegebenem Speisestrom i zu linearisieren, wobei sowohl geradpaarige als auch ungeradpaarige Nichtlinearitäten behoben werden. Die Definition der Nichtlinearität ist aus der Fig. 19 ersichtlich, in der eine nichtlineare Kennlinie $V_H = f(B)$ für einen gegebenen Speisestrom i dargestellt ist. Die linearisierte Kennlinie ist in der Fig. 19 gestrichelt wiedergegeben. Bei einem bestimmten Wert $B = B_1$ der Induktion B besitzt die nichtlineare Kennlinie der Hallspannung $V_H$ einen Arbeitspunkt X, dessen Ordinate gleich $V_H(B_1)$ ist, während der entsprechende Arbeitspunkt Y auf der linearen Kennlinie die Ordinate

$$\left[ \frac{\partial V_H}{\partial B} \right]_{B=0} \cdot B_1$$

hat, wobei der Faktor

$$\left[ \frac{\partial V_H}{\partial B} \right]_{B=0}$$

sowohl die Steigung der nichtlinearen als auch die Steigung der linearen Kennlinie im Nullpunkt $B = 0$ darstellt. Die Nichtlinearität $\varepsilon(B_1)$ beim Wert $B = B_1$ ist definiert als Differenz der Ordinaten der beiden Arbeitspunkte Y und X. D.h. :

$$\epsilon(B_1) = \left[ \frac{\partial V_H}{\partial B} \right]_{B=0} \cdot B_1 - V_H(B_1).$$

Die Nichtlinearität ist vom geradpaarigen Typ, wenn :

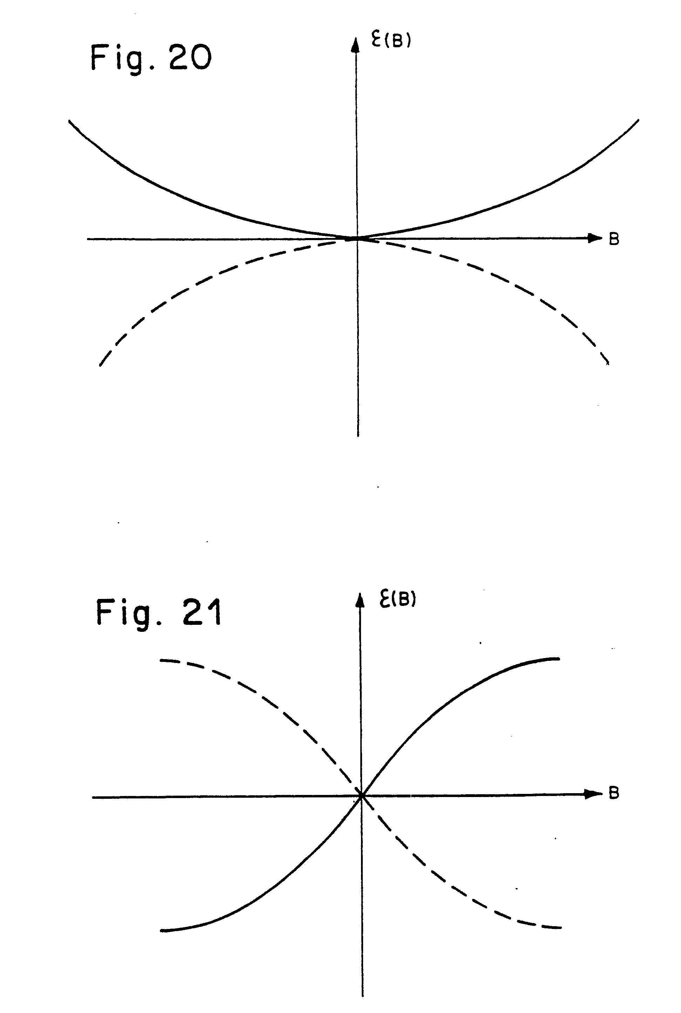

$\epsilon(B_1) = \epsilon(-B_1)$       (siehe Fig. 20).

Die Nichtlinearität ist vom ungeradpaarigen Typ, wenn :

$\epsilon(B_1) = -\epsilon(-B_1)$       (siehe Fig. 21).

Die in der Fig. 19 dargestellte Nichtlinearität ist vom ungeradpaarigen Typ.

Ob die Nichtlinearität eines gegebenen Hallelementes 1 vom geradpaarigen oder vom ungeradpaarigen Typ ist, muss vor dem Einbau des Hallelementes 1 in der Fig. 18 dargestellten Schaltung mit Hilfe z.B. einer Messung ermittelt werden. Die nachfolgende Funktionsbeschreibung gilt unter der Annahme, dass den positiven Werten der Induktion B auch positive Werte der Ausgangsspannung $V_H$ des Hallelementes 1 und den negativen Werten der Induktion B auch negative Werte der Ausgansspannung $V_H$ entsprechen (siehe Fig. 19).

Bie einem Hallelement vom geradpaarigen Typ ist in der Regel die Nichtlinearität $\epsilon(B)$ in Funktion der Induktion B entweder immer positiv, wie in der Fig. 20 als nichtgestrichele Kennlinie dargestellt, oder immer negativ, wie in der Fig. 20 als gestrichelte Kennlinie dargestellt.

Bei einem Hallelement vom ungeradpaarigen Typ ist in der Regel die Nichtlinearität $\epsilon(B)$ in Funktion der Induktion B entweder, wie in der Fig. 21 als nichtgestrichelte Kennlinie dargestellt, für positive Werte von B positiv und für negative Werte von B negativ, oder umgekehrt, wie in der Fig. 21 als gestrichelte Kennlinie dargestellt, für positive Werte von B negativ und für negative Werte von B positiv.

Ist das Hallelement 1 in idealer Weise vom geradpaarigen Typ, dann wird der vierte Eingang $E_4$ des Differenzverstärkers 26 nicht benutzt, d.h. die in der Fig. 18 gestrichelt gezeichnete fakultative Verbindung zwischen Ausgang des Spannungsfolgers 31 und vierten Eingang $E_4$ des Differenzverstärkers 26 fällt weg und nur der Absolutwert der Ausgangsspannung $V_H$ des Hallelementes 1 erreicht über den Istwertaufbereiter 24 den ersten Eingang $E_1$ des Differenzverstärkers 26.

Besitzt in diesem Fall das Hallelement 1 eine ähnliche Kennlinie wie diejenige, die in der Fig. 20 nichtgestrichelt dargestellt ist, und unter der Voraussetzung, dass der Spannungsfolger 31 einen positiven Verstärkungsfaktor + 1 besitzt, muss der Verstärker 27 ein invertierender Verstärker sein, so dass die Kaskadenschaltung 24 ; 26 ; 27 keine Spannungsinversion verursacht. Besitzt das Hallelement 1 dagegen eine ähnliche Kennlinie wie diejenige, die in der Fig. 20 gestrichelt dargestellt ist, muss der Verstärker 27 unter gleichen Voraussetzungen ein nichtinvertierender Verstärker sein, so dass die Kaskadenschaltung 24 ; 26 ; 27 eine Spannungsinversion verursacht. Ist das Hallelement 1 in idealer Weise vom ungeradpaarigen Typ, dann können das Steuergerät 28, der Umschalter 29 und der invertierende Verstärker 30 weggelassen werden, d.h. es wird kein Absolutwert der Ausgangsspannung $V_H$ des Hallelementes 1 gebildet und diese Ausgangsspannung $V_H$ erreicht über den Spannungsfolger 31 und einer fakultativ vorhandenen, daher in der Fig. 18 gestrichelt dargestellten Verbindung einen vierten Eingang $E_4$ des Differenzverstärkers 26. Im letzteren ist der vierte Eingang $E_4$ über einen dritten Eingangswiderstand $R_6$ mit dem invertierenden Eingang des Operationsverstärkers 33 verbunden.

Besitzt in diesem Fall das Hallelement 1 eine ähnliche Kennlinie wie diejenige, die in der Fig. 21 nichtgestrichelt dargestellt ist, und wieder unter der Voraussetzung, dass der Spannungsfolger 31 einen positiven Verstärkungsfaktor + 1 besitzt, muss der Verstärker 27 ein invertierender Verstärker sein, so dass die Kaskadenschaltung 31 ; 26 ; 27 keine Spannungsinversion verursacht. Besitzt das Hallelement 1 dagegen eine ähnliche Kennlinie wie diejenige, die in der Fig. 21 gestrichelt dargestellt ist, muss der Verstärker 27 unter gleichen Voraussetzungen ein nichtinvertierender Verstärker sein, so dass die Kaskadenschaltung 31 ; 26 ; 27 eine Spannungsinversion verursacht.

Die in den Figuren 20 und 21 dargestellten Kennlinien sind ideale Kennlinien. In der Praxis sind diese Kennlinien nicht so symmetrisch zur $\epsilon(B)$-Achse bzw. zum Nullpunkt angeordnet, d.h., in der Praxis ist in der Regel immer eine Mischung von Gleichpaarigkeit und Ungleichpaarigkeit vorhanden. In diesem Fall muss die Ausgangsspannung $V_H$ des Hallelementes 1 sowohl den ersten Eingang $E_1$ über den Istwertaufbereiter 24, als auch den vierten Eingang $E_4$ über den Spannungsfolger 31 erreichen. Da die Unsymmetrien bei gleichpaarigen und bei ungleichpaarigen Nichtlinearitäten nicht unbedingt gleich gross sind, können sie durch die Wahl unterschiedlicher Werte der Eingangswiderstände $R_3$ und $R_6$ ungleich stark korrigiert werden. Der erste und der vierte Eingang $E_1$ und $E_4$ des Differenzverstärkers 26 bilden somit je einen von zwei Istwerteingängen. Am vierten Eingang $E_4$ erscheint immer die Ausgangsspannung $V_H$ des Hallelementes 1 mit ihrem wirklichen Vorzeichen, während am ersten Eingang $E_1$ des Differenzverstärkers 26 immer der Absolutwert dieser Ausgangsspannung vorhanden ist. Die Summe der beiden an den beiden Eingängen $E_1$ und $E_4$ des Differenzverstärkers 26 anliegenden Spannungen bildet hier den Istwert der Regelungsschaltung 24 ; 25 ; 26 ; 27.

Kurz zusammengefasst kann die Arbeitsweise der in der Fig. 18 dargestellten Schaltung wie folgt beschrieben werden : Die Referenzspannungen $V_{Ref,1}$, $V_{Ref,2}$, $V_{Ref,3}$ und $V_{Ref,4}$ werden so gewählt, dass am Eingang des Verstärkers 27 ein positiver Sollwert ansteht, wenn der Verstärker 27 invertierend ist, und umgekehrt ein negativer Sollwert ansteht, wenn der Verstärker 27 nichtinvertierend ist, so dass in beiden Fällen am Steuereingang M des Hallelementes 1 eine negative Grundspannung als Sollwert ansteht. Ist das mittels des Hallelementes 1 gemessene Magnetfeld z.B. ein sinusförmiges Wechselmagnetfeld, so ist die Ausgangsspannung $V_H$ des Hallelementes 1 eine sinusförmige Wechselspannung. Bei einem Hallelement 1 mit idealer ungeradpaariger Nichtlinearität wird diese sinusförmige Wechselspannung $V_H$ unverändert dem vierten Eingang $E_4$ des Differenzverstärkers 26 als Istwert zugeführt und anschliessend, je nach positivem oder negativem Verstärkungsfaktor des Verstärkers 27 dem konstanten Sollwert mit oder ohne Inversion so überlagert, dass die negative Spannung am Steuereingang M des Hallelementes 1 in der richtigen Richtung weniger bzw. mehr negativ wird, wobei die Gesamtspannung am Steuereingang M auf jeden Fall negativ bleiben muss.

Bei einem Hallelement 1 mit idealer geradpaariger Nichtlinearität geschieht dasselbe, nur dass diesmal die negativen Halbwellen der Ausgangsspannung $V_H$ des Hallelementes 1 mit Hilfe des Umschalters 29 und des invertierenden Verstärkers 30 gleichgerichtet werden und die so gleichgerichtete Ausgangsspannung $V_H$ als Istwert dem ersten Eingang $E_1$ des Differenzverstärkers 26 zugeführt wird. Ist der Verstärkungsfaktor des invertierenden Verstärkers 30 gleich — 1, dann sind die gleichgerichteten negativen Halbwellen gleich gross wie die positiven Halbwellen, andernfalls ungleichgross. Bei einem Hallelement 1 mit unsymmetrischen Nichtlinearitäten, d.h. wenn eine Kombination geradpaariger und ungeradpaariger Nichtlinearitäten vorhanden ist, muss auch der Istwert eine Kombination der beiden obenerwähnten Istwerte sein, d.h. die unveränderte Ausgangsspannung $V_H$ muss dem Eingang $E_4$ und die gleichgerichte Ausgangsspannung $V_H$ muss dem Eingang $E_1$ gleichzeitig zugeführt werden. In diesem Fall wird die Summe der gewichteten Ausgangsspannung $V_H$ und der gewichteten gleichgerichteten Ausgangsspannung $V_H$ als Gesamtistwert wirksam, wobei die Werte der Eingangswiderstände $R_6$ bzw. $R_3$ jeweils den Gewichtsfaktor bilden.

Da bei einem gegebenen Magnetfeld die Empfindlichkeit und damit auch die Ausgangsspannung $V_H$ des Hallelementes 1 annähernd umgekehrt proportional zur Dicke der Sperrschicht ist und diese Dicke anderseits proportional der Spannung ist, die am Steuereingang M ansteht, wird die Nichtlinearität der Ausgangsspannung $V_H$ korrigiert, wenn die Spannung am Steuereingang M des Hallelements 1 regelungstechnisch in der richtigen Richtung verändert wird.

**Patentansprüche**

1. Einrichtung mit einem in einer integrierten Schaltung integrierbaren Hallelement, das zwei Sensor-Anschlusskontakte und mindestens zwei Strom-Anschlusskontakte besitzt, die grösstenteils an einer Oberfläche im Hallelement angeordnet sind, dessen aktive Zone mindestens seitlich von einem Ring umgeben ist, der einen Ringanschluss besitzt und vom entgegengesetzten Materialleitfähigkeitstyp ist wie die aktive Zone und die Anschlusskontakte des Hallelementes, dadurch gekennzeichnet, dass das Hallelement (1) im Innern des Halbleitermaterials vergraben ist, dass der Ring (8) durch eine Deckplatte (9) und eine Bodenplatte (10) so erweitert ist, dass der erweiterte Ring (8 ; 9 ; 10 bzw. 11) die aktive Zone (7) des Hallelementes (1) nach allen Richtungen hin umgibt, dass die Sensor- und Strom-Anschlusskontakte (2 bis 6) des Hallelementes (1) die Deckplatte (9) oder die Bodenplatte (10) durchqueren bis zum elektrischen Kontakt mit der aktiven Zone (7) des Hallelementes (1) und dass der Ring (8), die Deckplatte (9) und die Bondenplatte (10) vom gleichen Materialleitfähigkeitstyp sind und alle elektrischen Kontakt miteinander haben.

2. Einrichtung nach Anspruch 1, dadurch gekennzeichnet, dass der Ausgang ($S_1$) des Hallelementes (1) über eine Regelungsschaltung (24 ; 25 ; 26 ; 27) mit dem Ringanschluss (R) des Hallelementes (1) verbunden ist.

3. Einrichtung nach Anspruch 2, dadurch gekennzeichnet, dass die Regelungsschaltung (24 ; 25 ; 26 ; 27) mindestens aus einem Istwertaufbereiter (24), einem Sollwertgeber (25) und einem Sollwert/Istwert-Differenzgeber (26 ; 27) besteht.

4. Einrichtung nach Anspruch 3, dadurch gekennzeichnet, dass der Istwertaufbereiter (24) ein Absolutwertbildner ist.

5. Einrichtung nach Anspruch 4, dadurch gekennzeichnet, dass der Istwertaufbereiter (24) mindestens aus einem von einem Steuergerät (28) gesteuerten Umschalter (29) und aus einem invertierenden Verstärker (30) besteht.

6. Einrichtung nach Anspruch 5, dadurch gekennzeichnet, dass das Steuergerät (28) aus einem Komparator besteht.

7. Einrichtung nach Anspruch 4, dadurch gekennzeichnet, dass der Istwertaufbereiter (24) aus einem Gleichrichter besteht.

8. Einrichtung nach einem der Ansprüche 3 bis 7, dadurch gekennzeichnet, dass der Sollwertgeber (25) aus der Reihenschaltung eines Vorwiderstandes (R') und der « Source-Drain »-Strecke eines Feldeffekttransistors (32) besteht.

9. Einrichtung nach einem der Ansprüche 3 bis 8, dadurch gekennzeichnet, dass der Soll-

wert/Istwert-Differenzgeber (26 ; 27) mindestens aus einem Differenzverstärker (26) besteht.

10. Einrichtung nach Anspruch 9, dadurch gekennzeichnet, dass der Differenzverstärker (26) als invertierender Verstärker beschaltet ist und ihm ein weiterer invertierender Verstärker (27) in Kaskade nachgeschaltet ist.

11. Einrichtung nach Anspruch 9 oder 10, dadurch gekennzeichnet, dass der Differenzverstärker (26) zwei Istwerteingänge ($E_1$, $E_4$) besitzt, wovon der erste ($E_1$) mit dem Ausgang und der andere ($E_4$) mit dem Eingang des Istwertaufbereiters (24) verbunden ist.

12. Einrichtung nach einem der Ansprüche 2 bis 11, dadurch gekennzeichnet, dass in der Regelungsschaltung (24 ; 25 ; 26 ; 27) verwendete Transistoren (z.B. 32) ebenfalls je einen erweiterten Ring (8 ; 9 ; 10) besitzen, der gleich aufgebaut ist wie derjenige des Hallelementes (1).

13. Einrichtung nach einem der Ansprüche 1 bis 12, dadurch gekennzeichnet, dass der erweiterte Ring (8 ; 9 ; 10 bzw. 11) aus einem Stück ist und der Ring (8), die Deckplatte (9) und die Bodenplatte (10) demnach aus einem gleichen Material bestehen.

14. Einrichtung nach einem der Ansprüche 1 bis 12, dadurch gekennzeichnet, dass der Ring (8) aus stark mit Aluminium-Fremdatomen dotiertem Material besteht.

15. Einrichtung nach Anspruch 14, dadurch gekennzeichnet, dass alle Sensor- und Stromanschlusskontakte (2, 3, 5 und 6) in gleicher Anzahl mehrfach vorhanden sind, dass alle gleichnamigen Strom- und Sensor-Anschlusskontakte (2, 2', 2'' bzw. 3, 3', 3'' bzw. 5, 5', 5'' bzw. 6, 6', 6'') extern durch je eine elektrische Verbindung miteinander verbunden sind, dass der Ring (8) Zwischenstege (14, 15) besitzt, die den Ring (8) in nebeneinanderliegende Unterringe (I, II, III) unterteilen, wobei jeweils ein Zwischensteg (14, 15) zwei benachbarten Unterringen (I, II bzw. II, III) gemeinsam ist und wobei die Aufteilung des Ringes (8) in Unterringe (I, II, III) dergestalt ist, dass jeder Unterring (I, II, III) eine aktive Zone (7', 7, 7'') mit einer zugehörigen vollständigen Gruppe (2', 3', 5', 6' bzw. 2, 3, 5, 6 bzw. 2'', 3'', 5'', 6'') von ungleichnamigen Strom- und Sensor-Anschlusskontakten seitlich umgibt.

16. Einrichtung nach einem der Ansprüche 1 bis 12, dadurch gekennzeichnet, dass der Ring (8) aus einer Oberflächenschicht besteht, die rund herum auf einem ringförmigen Träger (21) aus Siliziumoxyd oder Polysilizium aufgetragen ist, und dass die Bodenplatte (10) eine an der Grenze zwischen einem Substrat (12) und einer auf dem Substrat (12) aufgewachsenen Schicht (20) angeordnete vergrabene Schicht ist.

17. Einrichtung nach einem der Ansprüche 1 bis 12, dadurch gekennzeichnet, dass der Ring (8) rechteckförmig ist und nur aus zwei diametral gegenüberliegenden Seiten besteht, die je aus mindestens einer Oberflächenschicht, (8a bzw. 8b) gebildet sind, die die seitlichen Innenflächen je eines Luftschachtes (22a bzw. 22b) vollständig und durchgehend bedecken, wobei die Luftschächte (22a, 22b) ein Substrat (12), aus dem das Hallelement (1) hergestellt ist, vollständig durchgehend von der Oberfläche bis zur Bodenfläche durchqueren.

18. Einrichtung nach einem der Ansprüche 1 bis 12, dadurch gekennzeichnet, dass der Ring (8) rechteckförmig ist und aus mindestens vier Oberflächenschichten (8a, 8b, 8j, 8k) besteht, von denen je zwei und zwei diametral gegenüberliegen und die die seitlichen Innenflächen je eines Luftschachtes (22a, 22b, 22j, 22k) vollständig und durchgehend bedecken, wobei die Luftschächte (22a, 22b, 22j, 22k) ein Substrat (12), aus dem das Hallelement (1) hergestellt ist, vollständig durchgehend von der Oberfläche bis zur Bodenfläche durchqueren und wobei alle Obeflächenschichten (8a, 8b, 8j, 8k) elektrischen Kontakt miteinander haben.

19. Einrichtung nach Anspruch 17 oder 18, dadurch gekennzeichnet, dass mindestens zwei diametral gegenüberliegende Luftschächte durch Zwischenstege in Teilluftschächte (22a, 22c, 22e, 22g bzw. 22b, 22d, 22f, 22h) unterteilt sind, deren seitliche Innenflächen vollständig mit je einer durchgehenden Oberflächenschicht (8a, 8c, 8e, 8g, 8b, 8d, 8f bzw. 8h) bedeckt sind, dass alle Zwischenstege ausschliesslich aus zwei Oberflächenschichten zweier benachbarter Teilluftschächte bestehen und dass alle Oberflächenschichten (8a bis 8k) elektrischen Kontakt miteinander besitzen.

20. Verwendung der Einrichtung nach einem der Ansprüche 1 bis 19 in einem Leistungsmesser oder in einem Elektrizitätszähler zum Messen eines elektrischen Stromes oder zur Bildung eines Spannung/Strom-Produktes.

## Claims

1. A device comprising a Hall element which can be integrated in an integrated circuit and which has two sensor connecting contacts and at least two current connecting contacts, which for the main part are arranged at a surface in the Hall element whose active zone is at least laterally surrounded by a ring which has a ring connection and which is of opposite material conductivity type to the active zone and the connecting contacts of the Hall element, characterised in that the Hall element (1) is buried in the interior of the semiconductor material, that the ring (8) is extended by a cover plate (9) and a bottom plate (10) so that the extended ring (8 ; 9 ; 10 or 11) surrounds the active zone (7) of the Hall element (1) in all directions, that the sensor and current connecting contacts (2 to 6) of the Hall element (1) pass through the cover plate (9) or the bottom plate (10) until making electrical contact with the active zone (7) of the Hall element (1), and that the ring (8), the cover plate (9) and the bottom plate (10) are of the same material conductivity type and are all in electrical contact with each other.

2. A device according to claim 1 characterised in that the output ($S_1$) of the Hall element (1) is connected by way of a regulating circuit (24 ; 25 ; 26 ; 27) to the ring connecting (R) of the Hall element (1).

3. A device according to claim 2 characterised in that the regulating circuit (24 ; 25 ; 26 ; 27) comprises at least an actual value producing means (24), a reference value generator (25) and a reference value/actual value differencing means (26 ; 27).

4. A device according to claim 3 characterised in that the actual value producing means (24) is an absolute value forming means.

5. A device according to claim 4 characterised in that the actual value producing means (24) comprises at least one change-over switch (29) controlled by a control device (28) and an inverting amplifier (30).

6. A device according to claim 5 characterised in that the control device (28) comprises a comparator.

7. A device according to claim 4 characterised in that the actual value producing means (24) comprises a rectifier.

8. A device according to one of claims 3 to 7 characterised in that the reference value generator (25) comprises the series connection of a series resistor (R') and the source-drain path of a field effect transistor (32).

9. A device according to one of claims 3 to 8 characterised in that the reference value/actual value differencing means (26 ; 27) comprises at least a differential amplifier (26).

10. A device according to claim 9 characterised in that the differential amplifier (26) is connected as an inverting amplifier and connected on the output side thereof in cascade relationship is a further inverting amplifier (27).

11. A device according to claim 9 or claim 10 characterised in that the differential amplifier (26) has two actual value inputs ($E_1$, $E_4$) of which the first ($E_1$) is connected to the output and the other ($E_4$) is connected to the input of the actual value producing means (24).

12. A device according to one of claims 23 to 11 characterised in that transistors (for example 32) used in the regulating circuit (24 ; 25 ; 26 ; 27) also each have an extended ring (8 ; 9 ; 10) which is of the same configuration as that of the Hall element (1).

13. A device according to one of claims 1 to 12 characterised in that the extended ring (8 ; 9 ; 10 or 11) is in one piece and the ring (8), the cover plate (9) and the bottom plate (10) accordingly consist of the same material.

14. A device according to one of claims 1 to 12 characterised in that the ring (8) comprises material which is heavily doped with aluminium impurity atoms.

15. A device according to claim 14 characterised in that all sensor and current connecting contacts (2, 3, 5 and 6) are provided in the same plurality, that all current and sensor connecting contacts (2, 2', 2" and 3, 3', 3" and 5, 5', 5" and 6, 6', 6") of the same designation are externally connected together by respective electrical connections, that the ring (8) has intermediate web portions (14, 15) which subdivide the ring (8) into juxtaposed sub-rings (I, II, III), wherein each respective intermediate web portion (14, 15) is common to two adjacent sub-rings (I, II and II, III) and wherein the division of the ring (8) into sub-rings (I, II, III) is such that each sub-ring (I, II, III) laterally surrounds an active zone (7', 7, 7") with an associated complete group (2', 3', 5', 6' and 2, 3, 5, 6 and 2", 3", 5", 6") of current and sensor connecting contacts of unlike designation.

16. A device according to one of claims 1 to 12 characterised in that the ring (8) comprises a surface layer which is applied on an annular carrier (21) of silicon oxide or polysilicon therearound, and that the bottom plate (10) is a buried layer which is arranged at the interface between a substrate (12) and a layer (20) grown on the substrate (12).

17. A device according to one of claims 1 to 12 characterised in that the ring (8) is rectangular and comprises only two diametrally opposite sides which are each formed from at least one surface layer (8a and 8b) which completely and continuously cover the lateral inside surfaces of a respective air shaft (22a and 22b), wherein the air shafts (22a, 22b) pass completely continuously through a substrate (12) from which the Hall element (1) is made, from the top surface to the bottom surface thereof.

18. A device according to one of claims 1 to 12 characterised in that the ring (8) is rectangular and comprises at least four surface layers (8a, 8b, 8j, 8k) which are disposed in diametrally opposite relationship in pairs and which completely and continuously cover the lateral inside surfaces of a respective air shaft (22a, 22b, 22j, 22k) wherein the air shafts (22a, 22b, 22j, 22k) pass completely continuously through a substrate (12) from which the Hall element (1) is made, from the top surface to the bottom surface thereof, and wherein all surface layers (8a, 8b, 8j, 8k) are in electrical contact with each other.

19. A device according to claim 17 or claim 18 characterised in that a least two diametrally opposite air shafts are subdivided by intermediate web portions into partial air shafts (22a, 22c, 22e, 22g and 22b, 22d, 22f, 22h) whose lateral inside surfaces are each completely covered by a continuous surface layer (8a, 8c, 8e, 8g, 8b, 8d, 8f and 8h), that all intermediate web portions consist exclusively of two surface layers of two adjacent partial air shafts and that all surface layers (8a to 8k) are in electrical contact with

12

each other.

20. Use of the device according to one of claims 1 to 19 in a wattmeter or in an electricity meter for measuring an electrical current or for forming a voltage/current product.

## Revendications

1. Dispositif comprenant un élément à effet Hall intégrable dans un circuit intégré, élément comportant au moins deux bornes de détection et au moins deux bornes d'alimentation, lesquelles pour l'essentiel sont disposées sur une face supérieure de l'élément à effet Hall, dont la zone active est au moins latéralement entourée par un anneau, lequel possède une borne d'anneau et est constitué en un matériau de type de conductivité opposée à celle de la zone active et des bornes de connexion de l'élément à effet Hall, caractérisé en ce que l'élément à effet Hall (1) est inclus à l'intérieur du matériau semi-conducteur, en ce que l'anneau (8) est élargi par une plaque supérieure (9) et une plaque inférieure (10) de façon que l'anneau élargi (8 ; 9 ; 10 respectivement 11) entoure la zone active (7) de l'élément à effet Hall dans toutes les directions, en ce que les bornes de détection et d'alimentation (2 à 6) de l'élément à effet Hall traversent la plaque supérieure (9) ou la plaque inférieure (10) et entrent en contact électrique avec la zone active (7) de l'élément à effet Hall (1) et en ce que l'anneau (8), la plaque supérieure (9) et la plaque inférieure (10) sont en un matériau de même type de conductivité et sont tous en contact électrique mutuel.

2. Dispositif selon la revendication 1, caractérisé en ce que la sortie (S1) de l'élément à effet Hall (1) est reliée à la borne d'anneau (R) de l'élément à effet Hall (1) par l'intermédiaire d'un circuit de régulation (24 ; 25 ; 26 ; 27).

3. Dispositif selon la revendication 2, caractérisé en ce que le circuit de régulation (24 ; 25 ; 26 ; 27) comporte au moins un circuit détecteur de valeur instantanée (24), un circuit générateur de valeur de consigne (25) et un circuit soustracteur (26, 27) de la valeur instantanée à la valeur de consigne.

4. Dispositif selon la revendication 3, caractérisé en ce que le circuit détecteur de valeur instantanée (24) est un circuit générateur de valeur absolue.

5. Dispositif selon la revendication 4, caractérisé en ce que le circuit détecteur de valeur instantanée (24) comporte au moins un commutateur (29) commandé par un circuit de commande (28) et un amplificateur inverseur (30).

6. Dispositif selon la revendication 5, caractérisé en ce que le circuit de commande (28) est constitué par un comparateur.

7. Dispositif selon la revendication 4, caractérisé en ce que le circuit détecteur de valeur instantanée (24) est formé par un élément redresseur.

8. Dispositif selon l'une des revendications 3 à 7, caractérisé en ce que le circuit générateur de valeur de consigne (25) est formé par la connexion en série d'une résistance dissipatrice (R') et de la jonction source-drain d'un transistor à effet de champ (32).

9. Dispositif selon l'une des revendications 3 à 8, caractérisé en ce que le circuit soustracteur (26, 27) de la valeur instantanée à la valeur de consigne comporte au moins un amplificateur différentiel (26).

10. Dispositif selon la revendication 9, caractérisé en ce que l'amplificateur différentiel (26) est monté en amplificateur inverseur, un autre amplificateur inverseur (27) étant connecté en cascade à celui-ci.

11. Dispositif selon la revendication 9 ou 10, caractérisé en ce que l'amplificateur différentiel (26) comporte deux entrées de valeur instantanée (E1, E4) dont l'une (E1) est reliée à la sortie et l'autre (E4) est reliée à l'entrée du circuit détecteur de valeur instantanée (24).

12. Dispositif selon l'une des revendications 2 à 11, caractérisé en ce que les transistors (par exemple 32) utilisés dans le circuit de régulation (24 ; 25 ; 26 ; 27) comportent chacun également un anneau élargi (8 ; 9 ; 10) lequel est réalisé identiquement à celui de l'élément à effet Hall (1).

13. Dispositif selon l'une des revendications 1 à 12, caractérisé en ce que l'anneau élargi (8 ; 9 ; 10 ; respectivement 11) est formé d'une pièce et l'anneau (8), la plaque supérieure (9) et la plaque inférieure (10) sont ainsi formées en un même matériau.

14. Dispositif selon l'une des revendications 1 à 12, caractérisé en ce que l'anneau (8) est formé par un matériau fortement dopé en atomes d'impuretés d'aluminium.

15. Dispositif selon la revendication 14, caractérisé en ce que toutes les bornes de détection et d'alimentation (2, 3, 5 et 6) sont prévues en une pluralité d'un même nombre, en ce que toutes les bornes d'alimentation et de détection d'un même nom (2, 2', 2'' respectivement 3, 3', 3'' respectivement 5, 5', 5'' respectivement 6, 6', 6'') sont chacune reliées ensemble de manière externe par une liaison électrique, en ce que l'anneau (8) comporte des entretoises (14, 15), lesquelles subdivisent l'anneau (8) en sous-anneaux (I, II, II) adjacents, de façon que au moins une entretoise (14, 15) est commune à deux sous-anneaux voisins (I, II respectivement II, III) et que le partage de l'anneau (8) en sous-anneaux (I, II, III) est de manière telle que chaque sous-anneau (I, II, III) entoure latéralement une zone active (7', 7, 7'') munie d'un groupe propre complet (2', 3', 5', 6' respectivement 2, 3, 5, 6 respectivement 2'', 3'', 5'', 6'') de bornes d'alimentation et de détection de noms différents.

16. Dispositif selon l'une des revendications 1 à 12, caractérisé en ce que l'anneau (8) consiste en une couche superficielle supérieure, laquelle est appliquée autour d'un support (21) en forme d'anneau

13

en oxyde de silicium ou en polysilicium, et en ce que la plaque inférieure (10) est une couche enfouie placée à la limite entre un substrat (12) et une couche (20) épitaxiée sur le substrat (12).

17. Dispositif selon l'une des revendications 1 à 12, caractérisé en ce que l'anneau (8) est rectangulaire et consiste seulement en deux côtés diamétralement opposés, lesquels sont chacun formés par au moins une couche superficielle supérieure (8a respectivement 8b), lesquelles recouvrent entièrement et continûment les surfaces intérieures latérales d'un puits respectif (22a respectivement 22b), les puits (22a respectivement 22b) traversant entièrement et continûment un substrat (12) à partir duquel l'élément à effet Hall (1) est produit, de la surface supérieure à la surface inférieure.

18. Dispositif selon l'une des revendications 1 à 12, caractérisé en ce que l'anneau (8) est rectangulaire et consiste en au moins quatre couches superficielles supérieures (8a, 8b, 8j, 8k), lesquelles sont deux à deux diamétralement opposées et recouvrent entièrement et continûment les surfaces intérieures latérales d'un puits (22a, 22b, 22j, 22k), de façon que les puits (22a, 22b, 22j, 22k) traversent entièrement et continûment un substrat (12) à partir duquel l'élément à effet Hall (1) est produit, de la surface supérieure à la surface inférieure.

19. Dispositif selon la revendication 17 ou 18, caractérisé en ce qu'au moins deux puits diamétralement opposés sont subdivisés par des entretoises en puits partiels (22a, 22c, 22e, 22g respectivement 22b, 22d, 22f, 22h) dont les surfaces intérieures latérales sont totalement recouvertes par une couche superficielle supérieure continue respective (8a, 8c ; 8g, 8b, 8d, 8f respectivement 8h), en ce que toutes les entretoises consistent exclusivement en deux couches superficielles de deux puits partiels voisins, et en ce que toutes les couches superficielles supérieures (8a à 8k) comportent entre elles des contacts électriques.

20. Utilisation d'un dispositif selon l'une des revendications 1 à 19 dans un wattmètre ou dans un compteur d'électricité pour la mesure d'un courant électrique ou pour la réalisation d'un produit tension/courant.

# Fig. 1

$S_1$   $C_1$ ↓ i   $S_2$

11   9

7   N   5   N⁺   2   N⁺   6   N⁺   R

P   1

2   2

# Fig. 2

R

9   $S_1$   9   $C_1$   9   $S_2$   9

5   N⁺   2   N⁺   6

8   N⁺   7   8

N

P   3   N⁺   11   1

10   i   C₂   10

1

# Fig. 3

# Fig. 4

2

# Fig. 5

# Fig. 6

# Fig. 7

4

# Fig. 8

# Fig. 9

# Fig. 10

# Fig. 11

## Fig. 12

## Fig. 13

# Fig. 14

# Fig. 15

# Fig. 16

Fig. 17

$V_{DD}$ $S_1$ $S_2$

$V_{SS}$ 23

$H_N$ $R_1$ $C'2$ $C1$ $C''2$ $R_2$

i/2 i i/2

3 5 2 6 4

11 1

R

Fig. 18

i $C_1$ 1 $S_1$ 28 24

R $S_2$ 30 $V_{Ref,1}$

23 $C_2$ 31 29 R'

$R_6$ $R_3$ $E_4$

27 $R_5$ $E_1$

− $R_4$ $E_2$ 32

$V_{Ref,2}$

F + 33 $V_{Ref,4}$ $V_{Ref,3}$

26 $E_3$ 25

Fig. 19

$V_H$

Y $\varepsilon(B_1)$

$V_H(B_1)$ X

$-B_1$ B

$B_1$

$\varepsilon(-B_1) = -\varepsilon(B_1)$

10

Fig. 20

Fig. 21

11